# EUROPEAN PATENT APPLICATION

(11) **EP 4 589 650 A1**
(43) Date of publication of application: **23.07.2025**
(21) Application number: 22958848.8
(22) Date of filing: 16.09.2022
(51) Int. Cl.: H01L 21/82, H10B 43/10

(54) **SEMICONDUCTOR DEVICE, METHOD FOR DESIGNING SAME, AND METHOD FOR MANUFACTURING SAME**

(71) Applicant: Kioxia Corporation, Tokyo 108-0023 (JP)
(72) Inventor: WATANABE, Yoshinori, Yokohama-shi, Kanagawa 247-0006 (JP); YAMANO, Satoshi, Yokohama-shi, Kanagawa 247-0006 (JP)
(74) Representative: Hoffmann Eitle
(86) International application number: PCT/JP2022/034748
(87) International publication number: WO 2024/057528

(57) **Abstract**

According to an embodiment, a semiconductor device includes a first cell. The first cell includes, a first PMOS transistor, a second PMOS transistor arranged side by side with the first PMOS transistor, a first NMOS transistor, a second NMOS transistor arranged side by side with the first NMOS transistor, and a seventh interconnect not electrically coupled to the first PMOS transistor, the second PMOS transistor, the first NMOS transistor, and the second NMOS transistor.

## Description

### FIELD

Embodiments described herein relate generally to a semiconductor device, a method for designing the same, and a method for manufacturing the same.

### BACKGROUND

In a layout design of a semiconductor device, an automatic place and route technique of automatically performing placement and interconnect coupling of cells may be used.

### CITATION LIST

### PATENT LITERATURE

Patent Literature 1: Jpn. Pat. Appln. KOKAI Publication No. 2012-43894

### SUMMARY

### TECHNICAL PROBLEM

An embodiment of the present invention provides a semiconductor device capable of suppressing an increase in development cost and an extension of a development work period.

### SOLUTION TO PROBLEM

A semiconductor device according to an embodiment includes a first cell. The first cell includes a first PMOS transistor, a second PMOS transistor arranged side by side with the first PMOS transistor in a first direction and configured to share one end with one end of the first PMOS transistor, a first NMOS transistor arranged side by side with the first PMOS transistor in a second direction intersecting the first direction, a second NMOS transistor arranged side by side with the first NMOS transistor in the first direction and configured to share one end with one end of the first NMOS transistor, a first interconnect electrically coupled to another end of the first PMOS transistor, a second interconnect electrically coupled to the one end of the first PMOS transistor and the one end of the second PMOS transistor, a third interconnect electrically coupled to another end of the second PMOS transistor, a power supply voltage interconnect extending in the second direction, provided above the first interconnect, the second interconnect, and the third interconnect, and electrically coupled to the first interconnect, the second interconnect, and the third interconnect, a fourth interconnect electrically coupled to another end of the first NMOS transistor, a fifth interconnect electrically coupled to the one end of the first NMOS transistor and the one end of the second NMOS transistor, a sixth interconnect electrically coupled to another end of the second NMOS transistor, a ground voltage interconnect extending in the second direction, provided above the fourth interconnect, the fifth interconnect, and the sixth interconnect, and electrically coupled to the fourth interconnect, the fifth interconnect, and the sixth interconnect, and a seventh interconnect provided in the same layer as the first to sixth interconnects and not electrically coupled to the first PMOS transistor, the second PMOS transistor, the first NMOS transistor, and the second NMOS transistor.

### BRIEF DESCRIPTION OF THE DRAWINGS

FIG. 1 is a block diagram illustrating an overall configuration of a semiconductor device according to a first embodiment.
FIG. 2 is a circuit diagram of a memory cell array included in the semiconductor device according to the first embodiment.
FIG. 3 is a cross-sectional view of a PMOS transistor included in the semiconductor device according to the first embodiment.
FIG. 4 is a cross-sectional view of an NMOS transistor included in the semiconductor device according to the first embodiment.
FIG. 5 is a plan view of a standard cell of a NAND circuit included in the semiconductor device according to the first embodiment.
FIG. 6 is a plan view of a standard cell of a NOR circuit included in the semiconductor device according to the first embodiment.
FIG. 7 is a plan view of a standard cell of an inverter circuit included in the semiconductor device according to the first embodiment.
FIG. 8 is a plan view of a standard cell of a buffer circuit included in the semiconductor device according to the first embodiment.
FIG. 9 is a plan view of a transistor of an ECO base cell included in the semiconductor device according to the first embodiment.
FIG. 10 is a plan view of an ECO base cell in which a decoupling capacitor included in the semiconductor device according to the first embodiment is configured.
FIG. 11 is an equivalent circuit diagram of the ECO base cell in which the decoupling capacitor included in the semiconductor device according to the first embodiment is configured.
FIG. 12 is a plan view of an ECO base cell in which the NAND circuit included in the semiconductor device according to the first embodiment is configured.
FIG. 13 is a plan view of an ECO base cell in which the NOR circuit included in the semiconductor device according to the first embodiment is configured.
FIG. 14 is a plan view of an ECO base cell in which the inverter circuit included in the semiconductor device according to the first embodiment is configured.
FIG. 15 is a plan view of an ECO base cell in which the buffer circuit included in the semiconductor device according to the first embodiment is configured.
FIG. 16 is a plan view of an ECO base cell in which a through cell included in the semiconductor device according to the first embodiment is configured.
FIG. 17 is an equivalent circuit diagram of the ECO base cell in which the through cell included in the semiconductor device according to the first embodiment is configured.
FIG. 18 is a plan view of a fill cell included in the semiconductor device according to the first embodiment.
FIG. 19 is a plan view illustrating a specific example of using the through cell in the semiconductor device according to the first embodiment.
FIG. 20 is a flowchart of a method for manufacturing the semiconductor device according to the first embodiment.
FIG. 21 is a flowchart of the method for manufacturing the semiconductor device according to the first embodiment.
FIG. 22 is a diagram illustrating an example of a planar layout after placement of the standard cell in a layout design of the semiconductor device according to the first embodiment.
FIG. 23 is a diagram illustrating an example of the planar layout after placement of the ECO base cell in which the decoupling capacitor is configured in the layout design of the semiconductor device according to the first embodiment.
FIG. 24 is a diagram illustrating an example of the planar layout after placement of the fill cell in the layout design of the semiconductor device according to the first embodiment.
FIG. 25 is a diagram illustrating an example of the planar layout after change of an ECO logic cell in the layout design of the semiconductor device according to the first embodiment.
FIG. 26 is a diagram illustrating an example of the planar layout after change to the through cell in the layout design of the semiconductor device according to the first embodiment.
FIG. 27 is a plan view illustrating a specific example of using a through cell in a semiconductor device according to a first modification of the first embodiment.
FIG. 28 is a plan view illustrating a specific example of using the through cell in the semiconductor device according to the first modification of the first embodiment.
FIG. 29 is a plan view illustrating a specific example of using the through cell in the semiconductor device according to the first modification of the first embodiment.
FIG. 30 is a plan view of a transistor of an ECO base cell included in a semiconductor device according to a second modification of the first embodiment.
FIG. 31 is a plan view of the transistor of the ECO base cell included in the semiconductor device according to the second modification of the first embodiment.
FIG. 32 is a plan view of an ECO base cell in which a through cell including a decoupling capacitor by an NMOS transistor included in a semiconductor device according to a third modification of the first embodiment is configured.
FIG. 33 is an equivalent circuit diagram of the ECO base cell in which the through cell including the decoupling capacitor by the NMOS transistor included in the semiconductor device according to the third modification of the first embodiment is configured.
FIG. 34 is a plan view of an ECO base cell in which a through cell including a decoupling capacitor by a PMOS transistor included in the semiconductor device according to the third modification of the first embodiment is configured.
FIG. 35 is an equivalent circuit diagram of the ECO base cell in which the through cell including the decoupling capacitor by the PMOS transistor included in the semiconductor device according to the third modification of the first embodiment is configured.
FIG. 36 is a flowchart of a method for manufacturing a semiconductor device according to a fourth modification of the first embodiment.
FIG. 37 is a flowchart of the method for manufacturing the semiconductor device according to the fourth modification of the first embodiment.
FIG. 38 is a block diagram illustrating an overall configuration of a semiconductor device according to a second embodiment.
FIG. 39 is a block diagram illustrating an overall configuration of a semiconductor device according to a third embodiment.
FIG. 40 is a block diagram illustrating an overall configuration of a semiconductor device according to a fourth embodiment.
FIG. 41 is a block diagram illustrating an overall configuration of a semiconductor device according to a fifth embodiment.
FIG. 42 is a circuit diagram of a memory cell array included in the semiconductor device according to the fifth embodiment.

### DETAILED DESCRIPTION

Embodiments will be described later with reference to the drawings. In the following description, components having substantially the same function and configuration are denoted by the same reference numerals. Redundant description may be omitted when unnecessary. In addition, each of the embodiments which will be described below illustrates an apparatus and a method for embodying the technical idea of the embodiment. The technical idea of the embodiments does not specify the materials, shapes, structures, placements, and the like of the components as follows. Various modifications can be made to the technical idea of the embodiments without departing from the gist of the invention. The embodiments and modifications thereof are included in the invention described in the claims and the equivalent scope thereof.

### 1. First embodiment

A semiconductor device according to a first embodiment will be described. In the present embodiment, a case where the semiconductor device is a NAND flash memory will be described. Note that a semiconductor device 1 may be a non-volatile semiconductor memory device other than the NAND flash memory. For example, the semiconductor device 1 may be a ferroelectric random access memory (FeRAM). Furthermore, the semiconductor device 1 may be a device other than the semiconductor memory device.

### 1.1 Overall configuration of semiconductor device

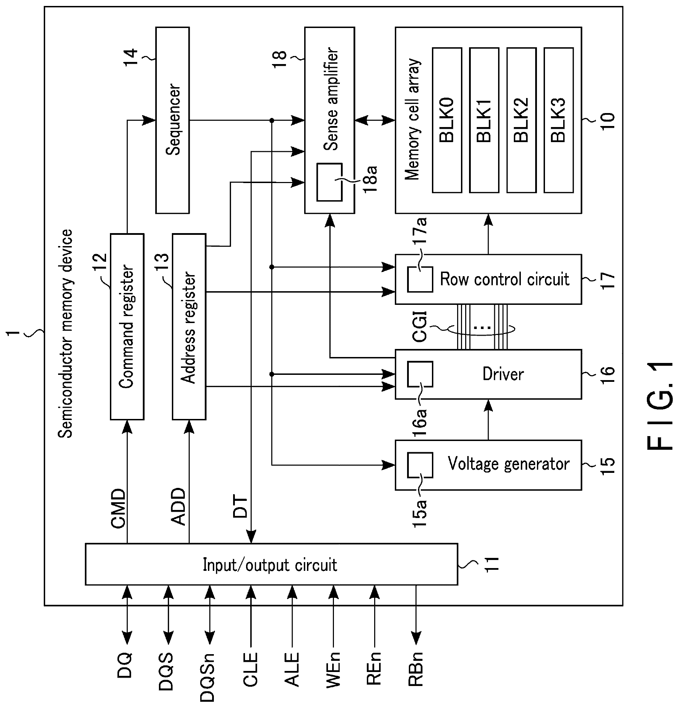

First, an example of an overall configuration of the semiconductor device 1 will be described with reference to FIG. 1. FIG. 1 is a block diagram illustrating the overall configuration of the semiconductor device 1. In FIG. 1, a part of coupling between components is indicated by an arrow line, but the coupling between the components is not limited thereto.

The semiconductor device 1 is, for example, a NAND flash memory. The NAND flash memory includes a plurality of non-volatile memory cell transistors (also referred to as memory cells).

The semiconductor device 1 is coupled to a controller (not illustrated) provided outside. The semiconductor device 1 operates based on an instruction from an external controller.

The semiconductor device 1 includes a memory cell array 10, an input/output circuit 11, a command register 12, an address register 13, a sequencer 14, a voltage generator 15, a driver 16, a row control circuit 17, and a sense amplifier 18.

The memory cell array 10 is a set of a plurality of arranged memory cell transistors. The memory cell array 10 includes a plurality of blocks BLK. In the example of FIG. 1, the memory cell array 10 includes four blocks BLK0, BLK1, BLK2, and BLK3. The blocks BLK are, for example, a set of a plurality of memory cell transistors from which data is collectively erased. Each memory cell transistor is associated with a row and a column. More specifically, a plurality of bit lines and a plurality of word lines are provided in the memory cell array 10. Each memory cell transistor is associated with, for example, one bit line and one word line. A detailed configuration of the memory cell array 10 will be described later.

The input/output circuit 11 is a circuit that inputs and outputs signals to and from an external controller. That is, the input/output circuit 11 functions as an interface circuit on the semiconductor device 1 side between the semiconductor device 1 and the external controller.

The input/output circuit 11 transmits and receives a signal DQ and clock signals DQS and DQSn to and from the external controller. For example, the signal DQ is data DT, address information ADD, or a command CMD. For example, the command CMD includes an instruction for causing the sequencer 14 to execute a read operation, a write operation, an erase operation, and the like. The clock signals DQS and DQSn are clock signals used at the time of input and output of the data DT. The clock signal DQSn is an inverted signal of the clock signal DQS.

The input/output circuit 11 is coupled to the command register 12, the address register 13, and the sense amplifier 18. The input/output circuit 11 sends the command CMD to the command register 12. The input/output circuit 11 sends the address information ADD to the address register 13. The input/output circuit 11 sends the data DT (write data) to the sense amplifier 18. In addition, the input/output circuit 11 receives the data DT (read data) from the sense amplifier 18.

The input/output circuit 11 receives various control signals from the external controller. For example, the semiconductor device 1 receives a command latch enable signal CLE, an address latch enable signal ALE, a write enable signal WEn, and a read enable signal REn from the external controller. The command latch enable signal CLE is a signal indicating that the signal DQ received from the external controller is the command CMD. The address latch enable signal ALE is a signal indicating that the signal DQ received from the external controller is the address information ADD. The write enable signal WEn is a signal that instructs the semiconductor device 1 to input the signal DQ. The read enable signal REn is a signal that instructs the semiconductor device 1 to output the signal DQ.

The input/output circuit 11 sends a ready/busy signal RBn to the external controller. The ready/busy signal RBn is a signal indicating whether the semiconductor device 1 is in a busy state or a ready state. The busy state is a state in which the semiconductor device 1 cannot receive the DQ signal from the external controller. The ready state is a state in which the semiconductor device 1 can receive the DQ signal from the external controller.

The input/output circuit 11 functions as, for example, a digital signal control circuit (also referred to as "logic circuit") that processes digital signals such as the signal DQ and the control signal received from the external controller.

The command register 12 temporarily stores the command CMD. The command register 12 is coupled to the sequencer 14. The command register 12 sends the command CMD to the sequencer 14.

The command register 12 has a function as a digital signal control circuit that processes the received digital signal (command CMD).

The address register 13 temporarily stores the address information ADD. For example, the address information ADD includes a block address, a page address (word line address), and a column address. The block address, the page address, and the column address are used to select the block BLK, the word line, and the bit line, respectively, in the memory cell array 10. The address register 13 is coupled to the driver 16, the row control circuit 17, and the sense amplifier 18. For example, the address register 13 sends the page address to the driver 16. The address register 13 sends the block address to the row control circuit 17. The address register 13 sends the column address to the sense amplifier 18. Hereinafter, the block BLK selected based on the block address is referred to as selected block BLK. The word line selected based on the page address is referred to as selected word line.

The address register 13 has a function as a digital signal control circuit that processes the received digital signal (address information ADD).

The sequencer 14 controls the entire operation of the semiconductor device 1. For example, the sequencer 14 is coupled to the voltage generator 15, the driver 16, the row control circuit 17, and the sense amplifier 18. The sequencer 14 controls the voltage generator 15, the driver 16, the row control circuit 17, the sense amplifier 18, and the like. For example, the sequencer 14 executes the read operation, the write operation, the erase operation, and the like based on the command CMD.

The sequencer 14 has a function as a digital signal control circuit that processes the received digital signal (for example, command CMD).

The voltage generator 15 generates various voltages under the control of the sequencer 14. The voltage generator 15 is coupled to the driver 16. The voltage generator 15 supplies the generated voltages to the driver 16.

The voltage generator 15 includes a digital signal control circuit 15a. The digital signal control circuit 15a is a circuit that processes the received digital signal (control signal received from the sequencer 14).

The driver 16 is a circuit that supplies voltages to the row control circuit 17 and the sense amplifier 18. The driver 16 is coupled to the row control circuit 17 and the sense amplifier 18. More specifically, the driver 16 supplies a plurality of voltages used in the read operation, the write operation, the erase operation, and the like to the row control circuit 17 and the sense amplifier 18 based on the control of the sequencer 14. The driver 16 is coupled to the row control circuit 17 via a plurality of interconnects CGI. For example, the driver 16 applies a predetermined voltage to each of the interconnects CGI based on the page address.

The driver 16 includes a digital signal control circuit 16a. The digital signal control circuit 16a is a circuit that processes the received digital signal (address information ADD and control signal received from the sequencer 14).

The row control circuit 17 is a circuit that controls interconnects (word lines and select gate lines) in a row direction of the memory cell array 10. The row control circuit 17 is coupled to the memory cell array 10. For example, the row control circuit 17 selects one block BLK in the memory cell array 10 based on the block address. For example, the row control circuit 17 transfers a voltage applied to the interconnect CGI corresponding to the selected word line to the selected word line in the selected block BLK.

The row control circuit 17 includes a digital signal control circuit 17a. The digital signal control circuit 17a is a circuit that processes the received digital signal (address information ADD and control signal received from the sequencer 14).

The sense amplifier 18 is a circuit that controls interconnects (bit lines) in a column direction of the memory cell array 10. The sense amplifier 18 is coupled to the memory cell array 10. In the write operation, the sense amplifier 18 applies a voltage to each bit line of the memory cell array 10 based on the write data DT. In addition, in the read operation, the sense amplifier 18 determines the data stored in the memory cell transistor based on the voltage of the bit line, and transfers a determination result to the input/output circuit 11 as read data DT.

The sense amplifier 18 includes a digital signal control circuit 18a. The digital signal control circuit 18a is a circuit that processes the received digital signal (address information ADD and control signal received from the sequencer 14).

### 1.2 Circuit configuration of memory cell array

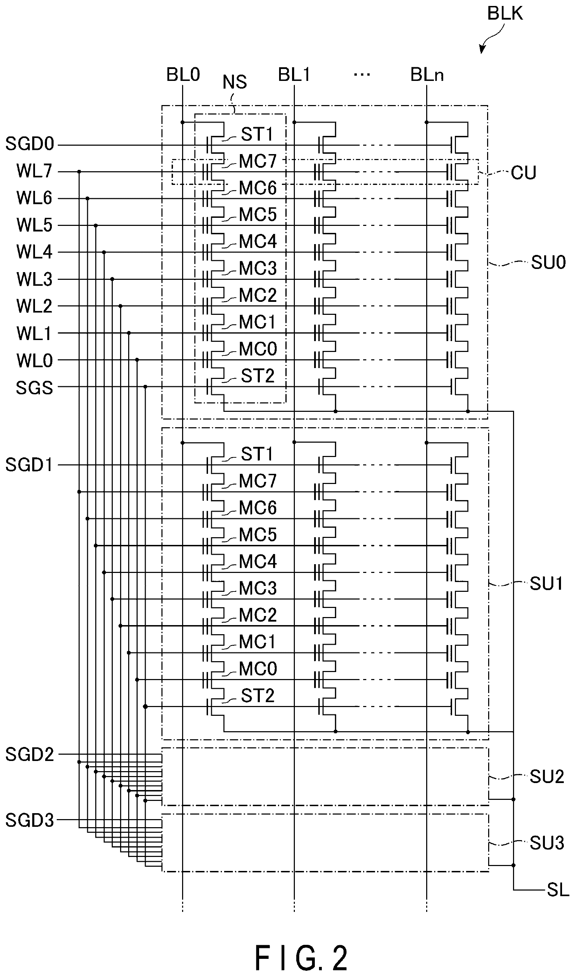

Next, an example of a circuit configuration of the memory cell array 10 will be described with reference to FIG. 2. FIG. 2 is a circuit diagram of the memory cell array 10. Note that the example of FIG. 2 illustrates a circuit configuration of one block BLK.

As illustrated in FIG. 2, the block BLK includes a plurality of string units SU. The string unit SU includes a plurality of NAND strings NS. In the example of FIG. 2, each block BLK includes four string units SU0 to SU3. The string unit SU is, for example, a set of a plurality of NAND strings collectively selected in the write operation or the read operation. Note that the number of blocks BLK in the memory cell array 10 and the number of string units SU in the block BLK are arbitrary.

The NAND string NS includes a plurality of memory cell transistors MC and selection transistors ST1 and ST2. In the example of FIG. 2, the NAND string NS includes eight memory cell transistors MC0 to MC7. Note that the number of memory cell transistors MC included in the NAND string NS is arbitrary.

The memory cell transistor MC is a memory element that stores data in a non-volatile manner. The memory cell transistor MC includes a control gate and a charge storage film. The memory cell transistor MC may be a metal-oxide-nitride-oxide-silicon (MONOS) type or a floating gate (FG) type. In the MONOS type, an insulating layer is used for the charge storage film. In the FG type, a conductor is used for the charge storage film.

The selection transistors ST1 and ST2 are switching elements. The selection transistors ST1 and ST2 are each used to select the string unit SU during various operations. The number of selection transistors ST1 and ST2 included in the NAND string NS is arbitrary. At least one each of the selection transistors ST1 and ST2 has only to be included in the NAND string NS.

Current paths of the selection transistor ST2, the memory cell transistors MC0 to MC7, and the selection transistor ST1 in the NAND string NS are coupled in series. A drain of the selection transistor ST1 is coupled to the bit line BL. A source of the selection transistor ST2 is coupled to a source line SL.

The control gates of the memory cell transistors MC0 to MC7 in the same block BLK are commonly coupled to the word lines WL0 to WL7, respectively. More specifically, the control gates of the memory cell transistors MC0 in the block BLK are commonly coupled to one word line WL0. The same applies to the memory cell transistors MC1 to MC7.

Gates of a plurality of the selection transistors ST1 in the string unit SU are commonly coupled to one select gate line SGD. More specifically, the gates of the selection transistors ST1 in the string unit SU0 are commonly coupled to a select gate line SGD0. The gates of the selection transistors ST1 in the string unit SU1 are commonly coupled to a select gate line SGD1. The gates of the selection transistors ST1 in the string unit SU2 are commonly coupled to a select gate line SGD2. The gates of the selection transistors ST1 in the string unit SU3 are commonly coupled to a select gate line SGD3.

Gates of a plurality of the selection transistors ST2 in the block BLK are commonly coupled to a select gate line SGS. Note that like the select gate line SGD, a different select gate line SGS may be provided for each string unit SU.

The word lines WL0 to WL7, the select gate lines SGD0 to SGD3, and the select gate line SGS are coupled to the row control circuit 17.

The bit line BL is commonly coupled to one NAND string NS in each string unit SU of each block BLK. The same column address is assigned to the NAND strings NS coupled to one bit line BL. Each bit line BL is coupled to the sense amplifier 18.

The source line SL is shared among the blocks BLK, for example.

A set of the memory cell transistors MC coupled to the common word line WL in one string unit SU is referred to as, for example, "cell unit CU". For example, the write operation and the read operation are executed in units of cell unit CU.

### 1.3 Automatic place and route

Next, automatic place and route will be described. In the present embodiment, an automatic place and route technique of a standard cell method is applied to layout design of various digital signal control circuits included in the semiconductor device 1. In the automatic place and route of the standard cell method, layout design is made by placing various cells (circuit blocks) side by side without gaps on a semiconductor substrate. For example, the circuit may be modified after the layout design. In such a case, correcting the layout while suppressing the change from original layout data as much as possible is referred to as engineering change order (ECO). The ECO includes a device ECO (also referred to as pre-mask ECO) and a metal ECO (also referred to as post-mask ECO). In the device ECO, a change including layout (hereinafter, also referred to as "device layout") of various cells (transistors/circuit blocks) is made. In the metal ECO, interconnect layout is changed without changing the device layout.

For example, a standard cell (also referred to as "logic cell"), an ECO base cell, and a fill cell are used for the automatic place and route. Hereinafter, when it is not specified whether the cell is the standard cell, the ECO base cell, or the fill cell, the cell is simply referred to as "cell".

The standard cell and the ECO base cell include a plurality of p-channel metal oxide semiconductor field effect transistor (MOSFETs) (hereinafter, referred to as "PMOS transistors") and n-channel MOSFETs (hereinafter, referred to as "NMOS transistors"). Hereinafter, when it is not specified whether the transistor is the PMOS transistor or the NMOS transistor, the transistor is simply referred to as "transistor".

The transistors in the cell are coupled to each other by an M1 interconnect of a lowermost layer. An M2 interconnect is provided above the M1 interconnect. A power supply voltage VDD or a ground voltage VSS is supplied to the transistor via the M2 interconnect. That is, the M2 interconnect functions as a power supply voltage interconnect or a ground voltage interconnect. An M3 interconnect is provided above the M2 interconnect. An M4 interconnect is provided above the M3 interconnect. For example, the M3 interconnect and M4 interconnect are used for coupling between the cells. The number of layers of the interconnects used for the automatic place and route is not limited to four. The number of layers of the interconnects used for the automatic place and route has only to be three or more.

The standard cell is a cell in which a NAND (exclusive AND) circuit, a NOR (exclusive OR) circuit, an inverter circuit, a buffer circuit, or the like is configured in advance. In the standard cell, the placement of the transistor and the M1 interconnect and the M2 interconnect coupled thereto is designed in advance. The type and number of transistors included in the standard cell are based on the circuit to be configured. The placement of the standard cell and the M3 interconnect and M4 interconnect coupled to the standard cell are determined by the automatic place and route.

The ECO base cell is a cell corresponding to the metal ECO. In the ECO base cell, the circuit function can be changed by changing the coupling between the transistors placed in the ECO base cell, that is, the layout of the M1 interconnect by the metal ECO. In the automatic place and route, the ECO base cell is placed in a gap after the standard cell is placed. For example, after the placement of the cell is completed, a change may occur in the circuit design. In such a case, by executing the metal ECO of the ECO base cell, it is possible to deal with the change in circuit design without changing the placement of the cell.

In the ECO base cell, the placement of the transistor is determined in advance. For example, the ECO base cell includes two PMOS transistors and two NMOS transistors. The placement of the ECO base cell and the M1 to M4 interconnects coupled to the respective transistors of the ECO base cell are designed by the automatic place and route.

The ECO base cell can configure the decoupling capacitor, the NAND circuit, the NOR circuit, the inverter circuit, or the buffer circuit according to the layout of the M1 interconnect. For example, in a case where the transistor in the ECO base cell is not used for the circuit configuration of the semiconductor device 1, that is, at a stage where the metal ECO is not executed, the decoupling capacitor is configured. By configuring the decoupling capacitor, a potential of each terminal of the transistor is determined. When the metal ECO is executed, the configuration of the ECO base cell can be changed from the decoupling capacitor to the NAND circuit, the NOR circuit, the inverter circuit, or the buffer circuit. Hereinafter, the ECO base cell in which the NAND circuit, the NOR circuit, the inverter circuit, or the buffer circuit is configured is also referred to as "ECO logic cell".

In addition, the ECO base cell of the present embodiment can configure a through cell by executing the metal ECO. The through cell includes an M1 interconnect coupled to a transistor in the through cell and an M1 interconnect used for coupling between two cells adjacent to the through cell. The M1 interconnect used for coupling of the adjacent cell is not coupled to the transistor in the through cell.

The fill cell is a cell placed in a gap after the standard cell and the ECO base cell are placed. The fill cell includes an M2 interconnect and an N-type well region corresponding to the PMOS transistor. The fill cell is not provided with a transistor. For example, a gap between the cells in a direction in which the M2 interconnect extends, if present, brings into a state in which the M2 interconnects, that is, the power supply voltage interconnect and the ground voltage interconnect are disconnected. By inserting the fill cell into the gap, the M2 interconnect between the adjacent cells is coupled. Similarly, an N-type well region between the adjacent cells is coupled by inserting the fill cell.

### 1.3.1 Cross-sectional configurations of PMOS transistor and NMOS transistor

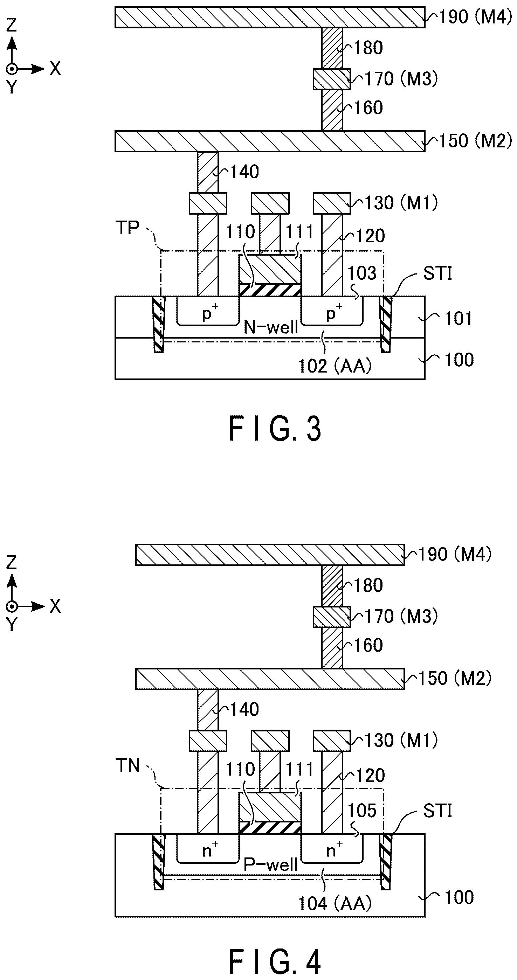

Next, an example of cross-sectional configurations of the PMOS transistor and the NMOS transistor will be described with reference to FIGS. 3 and 4. FIG. 3 is a cross-sectional view of the PMOS transistor. FIG. 4 is a cross-sectional view of the NMOS transistor. In the examples of FIGS. 3 and 4, an interlayer insulating film is omitted. In the following description, a direction parallel to a surface of the semiconductor substrate is referred to as X direction. A direction parallel to the surface of the semiconductor substrate and intersecting the X direction is defined as Y direction. A direction intersecting the semiconductor substrate and intersecting the X direction and the Y direction is defined as Z direction.

First, the cross-sectional configuration of a PMOS transistor TP will be described. As illustrated in FIG. 3, an N-type well region 101 is provided in the vicinity of a surface of a semiconductor substrate 100. The N-type well region 101 is doped with, for example, phosphorus (P). In the N-type well region 101, a region isolated by an element isolation region STI functions as an active area (AA) 102 of the PMOS transistor TP. For example, silicon oxide (SiO) is used for the element isolation region STI.

Two p⁺ impurity diffusion regions 103 are provided in the vicinity of a surface of the active area 102. The p⁺ impurity diffusion region 103 is doped with, for example, boron (B). The two p⁺ impurity diffusion regions 103 function as a source and a drain, respectively, of the PMOS transistor TP.

For example, the two p⁺ impurity diffusion regions 103 are disposed apart from each other in the X direction. A gate insulating film 110 is provided on the active area 102 between the two p⁺ impurity diffusion regions 103. The gate insulating film contains, for example, a metal oxide such as silicon oxide (SiO), silicon oxynitride (SiON), hafnium oxide (HfO), or hafnium oxynitride silicate (HfSiON).

A gate electrode 111 is provided on the gate insulating film. For example, the gate electrode 111 contains a conductive material such as polysilicon, tungsten (W), tungsten silicide (WSi), or titanium nitride (TiN). For example, the gate electrode 111 contains polysilicon or a stack of polysilicon and silicides such as nickel silicide (NiSi), nickel platinum silicide (NiPtSi), and cobalt silicide (CoSi). For example, the gate electrode 111 contains a stack of silicon nitride (SiN), polysilicon, and tungsten (W) and tungsten silicide (WSi). For example, the gate electrode 111 contains aluminum (Al), titanium (Ti), and tantalum (Ta). For example, the gate electrode 111 contains a stack of aluminum oxide (AlO), aluminum cobalt copper (AlCoCu), aluminum titanium nitride (AlTiN), aluminum titanium nitride (AlTiN), aluminum titanium oxynitride (AlTiON), tantalum nitride (TaN), and titanium nitride (TiN). For example, the gate electrode 111 contains a stack of silicides such as nickel silicide (NiSi), nickel platinum silicide (NiPtSi), and cobalt silicide (CoSi), polysilicon, and titanium nitride (TiN). For example, the gate electrode 111 contains a stack of tungsten (W), tungsten silicon nitride (WSiN), tungsten (W), titanium nitride (TiN), polysilicon, and titanium nitride (TiN). The stacks described here may not include all the layers but may include only some of the layers.

A contact plug 120 is provided on the p⁺ impurity diffusion region 103 and the gate electrode 111. For example, the contact plug 120 has a columnar shape extending in the Z direction.

An M1 interconnect 130 is provided on the contact plug 120.

A contact plug 140 is provided on the M1 interconnect 130. For example, the contact plug 140 has a columnar shape extending in the Z direction.

An M2 interconnect 150 is provided on the contact plug 140. For example, the M2 interconnect 150 extends in the X direction.

A contact plug 160 is provided on the M2 interconnect 150. For example, the contact plug 160 has a columnar shape extending in the Z direction.

An M3 interconnect 170 is provided on the contact plug 160. For example, the M3 interconnect 170 extends in the Y direction.

A contact plug 180 is provided on the M3 interconnect 170. For example, the contact plug 180 has a columnar shape extending in the Z direction.

An M4 interconnect 190 is provided on the contact plug 180. For example, the M4 interconnect 190 extends in the X direction.

The M1 interconnect 130 and the M2 interconnect 150 contain, for example, tungsten (W). The M3 interconnect 170 and the M4 interconnect 190 contain, for example, tungsten (W), copper (Cu), or aluminum (Al). The M1 interconnect 130, the M2 interconnect 150, the M3 interconnect 170, and the M4 interconnect 190 contain a barrier metal such as titanium nitride (TiN), tantalum nitride (TaN), or a stack of tantalum nitride (TaN) and tantalum (Ta).

Next, a cross-sectional configuration of an NMOS transistor TN will be described. As illustrated in FIG. 4, in the vicinity of the surface of the semiconductor substrate 100, a P-type well region is provided in a region surrounded by the element isolation region STI. The P-type well region functions as an active area 104 of the NMOS transistor TN.

Two n⁺ impurity diffusion regions 105 are provided in the vicinity of a surface of the active area 104. The n⁺ impurity diffusion region 105 is doped with, for example, phosphorus (P). The two n⁺ impurity diffusion regions 105 function as a source and a drain, respectively, of the NMOS transistor TN.

For example, the two n⁺ impurity diffusion regions 105 are disposed apart from each other in the X direction. A gate insulating film 110 is provided on the active area 104 between the two n⁺ impurity diffusion regions 103. A gate electrode 111 is provided on the gate insulating film.

A contact plug 120 is provided on the n⁺ impurity diffusion region 105 and the gate electrode 111. Configurations of the interconnects and the contact plugs above the contact plug 120 are similar to those described with reference to FIG. 3.

### 1.3.2 Planar configuration of standard cell

Next, an example of a planar configuration of the standard cell will be described. Hereinafter, the standard cells of the NAND circuit, the NOR circuit, the inverter circuit, and the buffer circuit will be described.

### 1.3.2.1 NAND circuit

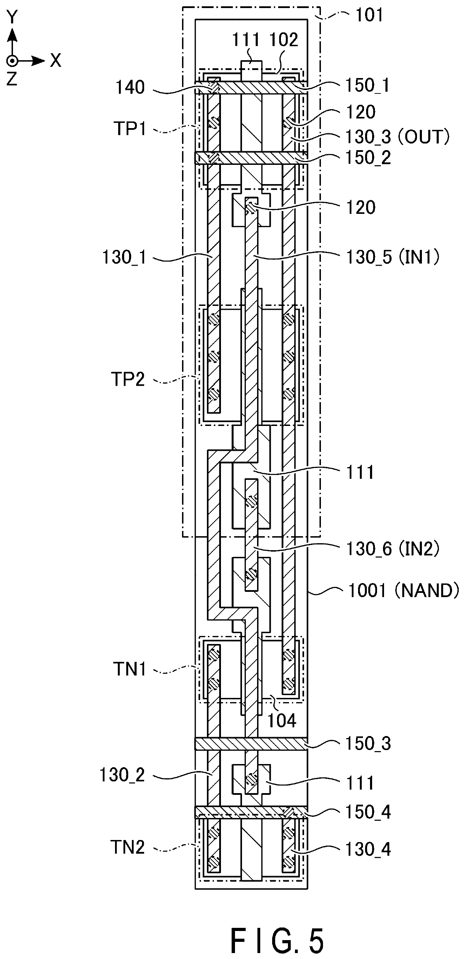

First, an example of the planar configuration of the standard cell of the NAND circuit will be described with reference to FIG. 5. FIG. 5 is a plan view of the standard cell of the NAND circuit. In the example of FIG. 5, the interlayer insulating film is omitted. In the following description, either the source or the drain of the transistor is referred to as one end of the transistor. The other of the source and the drain of the transistor is referred to as the other end of the transistor.

As illustrated in FIG. 5, for example, the standard cell has a rectangular shape in which a long side extends in the Y direction and a short side extends in the X direction. The same applies to the ECO base cell and the fill cell which will be described later.

For example, lengths of long sides of the respective cells (standard cell, ECO base cell, and fill cell) are the same because they are compatible with the automatic place and route. The lengths of the short sides of the respective cells vary depending on the configurations of the cells. In addition, positions of the M2 interconnects 150 and the N-type well regions 101 of the standard cell, the ECO base cell, and the fill cell in the Y direction are the same. When the respective cells are arranged side by side in the Y direction, the M2 interconnect 150 and the N-type well region 101 are coupled to each other between the cells.

A standard cell 1001 of the NAND circuit includes an N-type well region 101, PMOS transistors TP1 and TP2, NMOS transistors TN1 and TN2, M1 interconnects 130, M2 interconnects 150, and contact plugs 120 and 140.

In the example of FIG. 5, the N-type well region 101 is provided on the upper side, on the drawing sheet, of the standard cell 1001 of the NAND circuit.

The PMOS transistors TP1 and TP2 and the NMOS transistors TN1 and TN2 are arranged side by side in the Y direction. The PMOS transistors TP1 and TP2 are provided in the N-type well region 101. In other words, in the N-type well region 101, the active area 102 corresponding to the PMOS transistor TP1 and the active area 102 corresponding to the PMOS transistor TP2 are arranged side by side in the Y direction. In addition, the active area 104 corresponding to the NMOS transistor TN1 and the active area 104 corresponding to the NMOS transistor TN2 are arranged side by side in the Y direction.

The standard cell 1001 is provided with four M2 interconnects 150_1 to 150_4 extending in the X direction. For example, the M2 interconnects 150_1 and 150_2 provided above the N-type well region 101 (PMOS transistor TP) function as the power supply voltage interconnects. The M2 interconnects 150_3 and 150_4 provided above the NMOS transistor TN function as the ground voltage interconnects. Note that the number of M2 interconnects 150 functioning as the power supply voltage interconnect and the ground voltage interconnect may be one or three or more.

One ends of the PMOS transistors TP1 and TP2 are commonly coupled to the M2 interconnects 150_1 and 150_2 (power supply voltage interconnects) via an M1 interconnect 130_1.

One ends of the NMOS transistors TN1 and TN2 are commonly coupled via an M1 interconnect 130_2.

The other ends of the PMOS transistors TP1 and TP2 and the other end of the NMOS transistor TN1 are commonly coupled via an M1 interconnect 130_3. The M1 interconnect 130_3 functions as a signal output interconnect (OUT) of the NAND circuit.

The other end of the NMOS transistor TN2 is coupled to the M2 interconnect 150_4 (ground voltage interconnect) via an M1 interconnect 130_4.

The gate electrode 111 of the PMOS transistor TP1 is coupled to the gate electrode 111 of the NMOS transistor TN2 via an M1 interconnect 130_5. The M1 interconnect 130_5 functions as one signal input interconnect (IN1) of the NAND circuit.

The gate electrode 111 of the PMOS transistor TP2 is coupled to the gate electrode 111 of the NMOS transistor TN1 via an M1 interconnect 130_6. The M1 interconnect 130_6 functions as the other signal input interconnect (IN2) of the NAND circuit.

### 1.3.2.2 NOR circuit

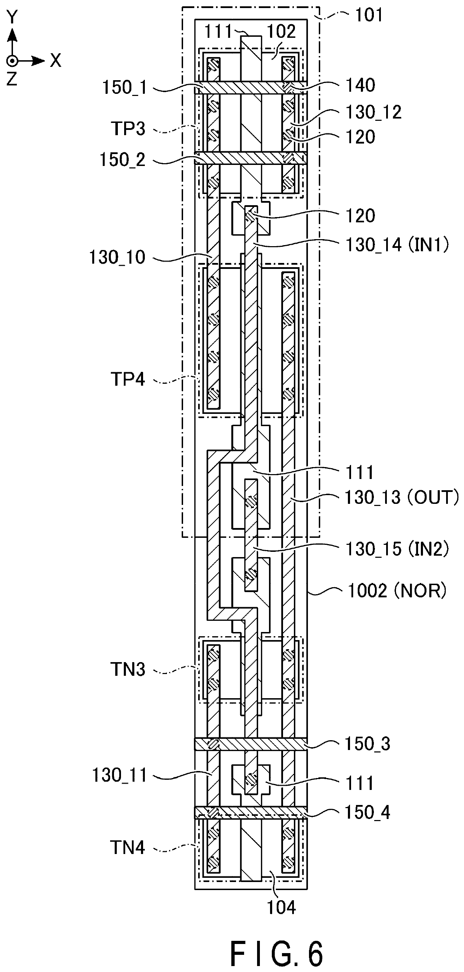

Next, an example of the planar configuration of the standard cell of the NOR circuit will be described with reference to FIG. 6. FIG. 6 is a plan view of the standard cell of the NOR circuit. In the example of FIG. 6, the interlayer insulating film is omitted.

As illustrated in FIG. 6, a standard cell 1002 of the NOR circuit includes an N-type well region 101, PMOS transistors TP3 and TP4, NMOS transistors TN3 and TN4, M1 interconnects 130, M2 interconnects 150, and contact plugs 120 and 140.

Similarly to the standard cell 1001, the standard cell 1002 is provided with the N-type well region 101 and M2 interconnects 150_1 to 150_4. Positions of the N-type well region 101 and the M2 interconnects 150_1 to 150_4 in the Y direction are similar to those in the standard cell 1001. The four M2 interconnects 150_1 to 150_4 each extend in the X direction.

The PMOS transistors TP3 and TP4 and the NMOS transistors TN3 and TN4 are arranged side by side in the Y direction. The PMOS transistors TP3 and TP4 are provided in the N-type well region 101. In the N-type well region 101, the active area 102 corresponding to the PMOS transistor TP3 and the active area 102 corresponding to the PMOS transistor TP4 are arranged side by side in the Y direction. In addition, the active area 104 corresponding to the NMOS transistor TN3 and the active area 104 corresponding to the NMOS transistor TN4 are arranged side by side in the Y direction.

One ends of the PMOS transistors TP3 and TP4 are commonly coupled via an M1 interconnect 130_10.

One ends of the NMOS transistors TN3 and TN4 are commonly coupled to the M2 interconnects 150_3 and 150_4 (ground voltage interconnects) via an M1 interconnect 130_11.

The other end of the PMOS transistor TP3 is coupled to the M2 interconnects 150_1 and 150_2 (power supply voltage interconnects) via an M1 interconnect 130_12.

The other end of the PMOS transistor TP4 and the other ends of the NMOS transistors TN3 and TN4 are commonly coupled via an M1 interconnect 130_13. The M1 interconnect 130_13 functions as a signal output interconnect (OUT) of the NOR circuit.

The gate electrode 111 of the PMOS transistor TP3 is coupled to the gate electrode 111 of the NMOS transistor TN4 via an M1 interconnect 130_14. The M1 interconnect 130_14 functions as one signal input interconnect (IN1) of the NOR circuit.

The gate electrode 111 of the PMOS transistor TP4 is coupled to the gate electrode 111 of the NMOS transistor TN3 via an M1 interconnect 130_15. The M1 interconnect 130_15 functions as the other signal input interconnect (IN2) of the NOR circuit.

### 1.3.2.3 inverter circuit

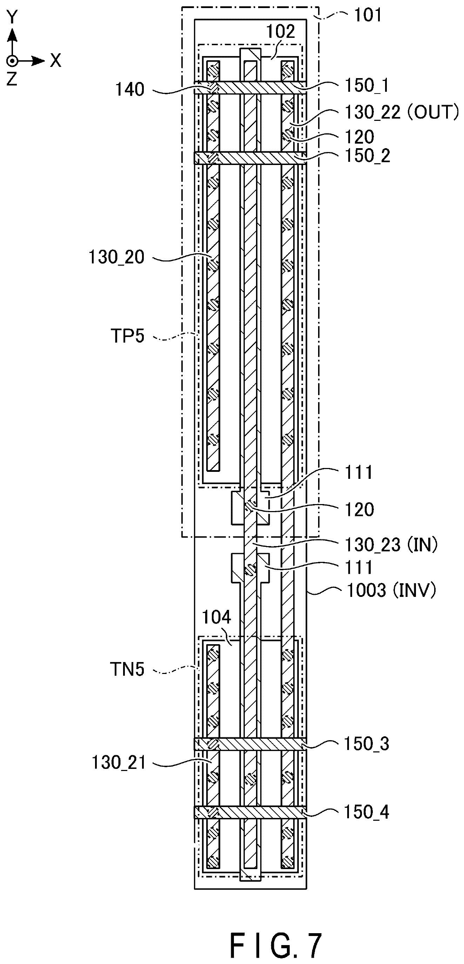

Next, an example of the planar configuration of the standard cell of the inverter circuit will be described with reference to FIG. 7. FIG. 7 is a plan view of the standard cell of the inverter circuit. In the example of FIG. 7, the interlayer insulating film is omitted.

As illustrated in FIG. 7, the standard cell 1003 of the inverter circuit includes an N-type well region 101, a PMOS transistor TP5, an NMOS transistor TN5, M1 interconnects 130, M2 interconnects 150, and contact plugs 120 and 140.

Similarly to the standard cell 1001, the standard cell 1003 is provided with the N-type well region 101 and M2 interconnects 150_1 to 150_4. Positions of the N-type well region 101 and the M2 interconnects 150_1 to 150_4 in the Y direction are similar to those in the standard cell 1001. The four M2 interconnects 150_1 to 150_4 each extend in the X direction.

The PMOS transistor TP5 and the NMOS transistor TN5 are arranged side by side in the Y direction. The PMOS transistor TP5 is provided in the N-type well region 101. The active area 102 corresponding to the PMOS transistor TP5 and the active area 104 corresponding to the NMOS transistor TN5 are arranged side by side in the Y direction.

One end of the PMOS transistor TP5 is coupled to the M2 interconnects 150_1 and 150_2 (power supply voltage interconnects) via an M1 interconnect 130_20.

One end of the NMOS transistor TN5 is coupled to the M2 interconnects 150_3 and 150_4 (ground voltage interconnects) via an M1 interconnect 130_21.

The other end of the PMOS transistor TP5 is coupled to the other end of the NMOS transistor TN5 via an M1 interconnect 130_22. The M1 interconnect 130_22 functions as a signal output interconnect (OUT) of the inverter circuit.

The gate electrode 111 of the PMOS transistor TP5 is coupled to the gate electrode 111 of the NMOS transistor TN5 via an M1 interconnect 130_23. The M1 interconnect 130_23 functions as a signal input interconnect (IN) of the inverter circuit.

### 1.3.2.4 Buffer circuit

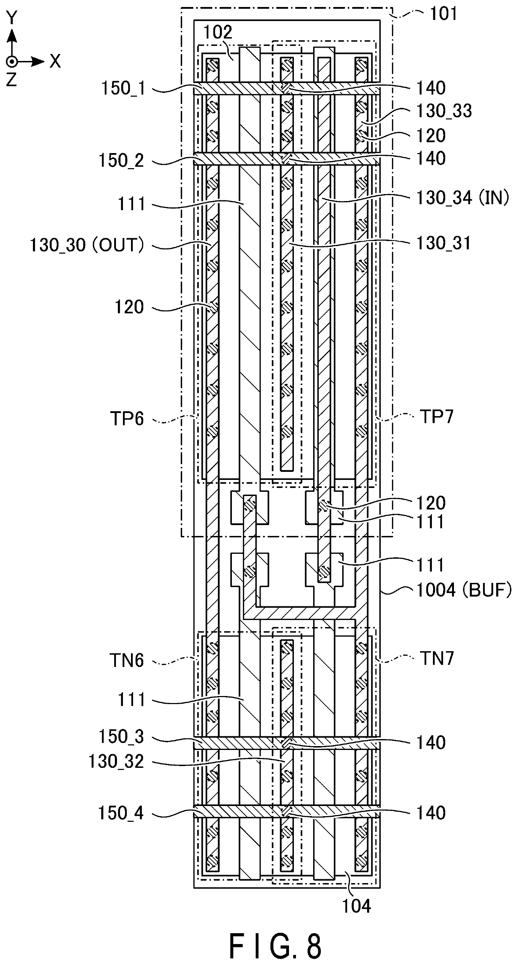

Next, an example of the planar configuration of the standard cell of the buffer circuit will be described with reference to FIG. 8. FIG. 8 is a plan view of the standard cell of the buffer circuit. In the example of FIG. 8, the interlayer insulating film is omitted.

As illustrated in FIG. 8, a standard cell 1004 of the buffer circuit includes an N-type well region 101, PMOS transistors TP6 and TP7, NMOS transistors TN6 and TN7, M1 interconnects 130, M2 interconnects 150, and contact plugs 120 and 140.

Similarly to the standard cell 1001, the standard cell 1004 is provided with the N-type well region 101 and M2 interconnects 150_1 to 150_4. Positions of the N-type well region 101 and the M2 interconnects 150_1 to 150_4 in the Y direction are similar to those in the standard cell 1001. The four M2 interconnects 150_1 to 150_4 each extend in the X direction.

The PMOS transistors TP6 and TP7 are provided in the N-type well region 101. The PMOS transistors TP6 and TP7 are provided in one active area 102. The PMOS transistors TP6 and TP7 are arranged side by side in the X direction. The PMOS transistors TP6 and TP7 share a source or a drain.

The NMOS transistors TN6 and TN7 are provided in one active area 104. The NMOS transistors TN6 and TN7 are arranged side by side in the X direction. The NMOS transistors TN6 and TN7 share a source or a drain.

One end of the PMOS transistor TP6 is coupled to one end of the NMOS transistor TN6 via an M1 interconnect 130_30. The M1 interconnect 130_30 functions as a signal output interconnect (OUT) of the buffer circuit.

One end shared by the PMOS transistors TP6 and TP7 (the other ends of the PMOS transistors TP6 and TP7) is commonly coupled to the M2 interconnects 150_1 and 150_2 (power supply voltage interconnects) via an M1 interconnect 130_31.

One end shared by the NMOS transistors TN6 and TN7 (the other ends of the NMOS transistors TN6 and TN6) is commonly coupled to the M2 interconnects 150_3 and 150_4 (ground voltage interconnects) via an M1 interconnect 130_32.

One end of the PMOS transistor TP7, one end of the NMOS transistor TN7, the gate electrode 111 of the PMOS transistor TP6, and the gate electrode 111 of the NMOS transistor TN6 are commonly coupled via an M1 interconnect 130_33.

The gate electrode 111 of the PMOS transistor TP7 and the gate electrode 111 of the NMOS transistor TN7 are commonly coupled via an M1 interconnect 130_34. The M1 interconnect 130_34 functions as a signal input interconnect (IN) of the buffer circuit.

### 1.3.3 Planar configuration of ECO base cell

Next, an example of the planar configuration of the ECO base cell will be described. Hereinafter, differences from the standard cell will be mainly described.

### 1.3.3.1 Planar configuration of transistor of ECO base cell

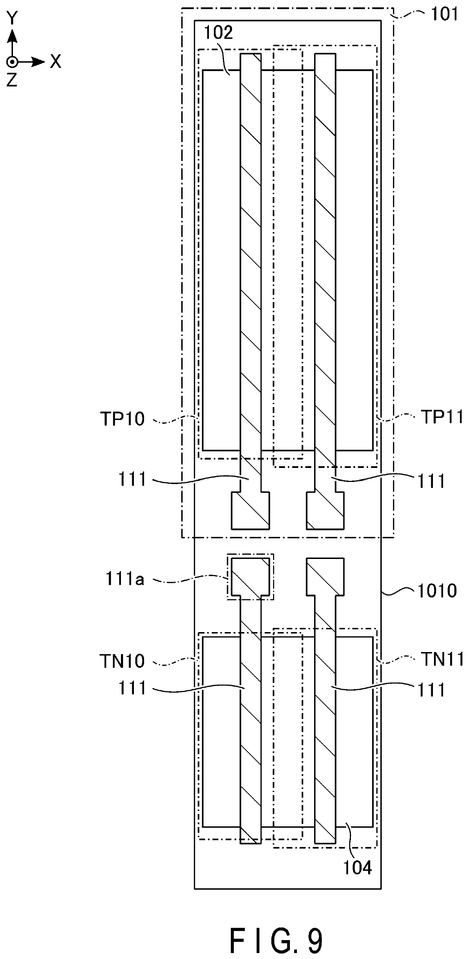

First, an example of the planar configuration of the transistor of the ECO base cell will be described with reference to FIG. 9. FIG. 9 is a plan view of the transistor of the ECO base cell. In the example of FIG. 9, the interlayer insulating film, M1 interconnect 130, M2 interconnect 150, and contact plugs 120 and 140 are omitted.

As shown in FIG. 9, an ECO base cell 1010 includes an N-type well region 101, PMOS transistors TP10 and TP11, and NMOS transistors TN10 and TN11.

Similarly to the standard cell 1001, the N-type well region 101 is provided on the upper side, on the drawing sheet, of the ECO base cell 1010. A position of the N-type well region 101 in the Y direction is similar to that in the standard cell 1001. Note that positions of M2 interconnects 150_1 to 150_4 (not illustrated) are also similar to those in the standard cell 1001.

The PMOS transistors TP10 and TP11 are provided in the N-type well region 101. The PMOS transistors TP10 and TP11 are provided in one active area 102. The PMOS transistors TP10 and TP11 are arranged side by side in the X direction. The PMOS transistors TP10 and TP11 share a source or a drain.

The NMOS transistors TN10 and TN11 are provided in one active area 104. The NMOS transistors TN10 and TN11 are arranged side by side in the X direction. The NMOS transistors TN10 and TN11 share a source or a drain.

In the example of FIG. 9, a coupling portion 111a with a contact plug 120 (not illustrated) is provided at an end portion of the gate electrode 111 of each transistor. A width of the coupling portion 111a in the X direction is larger than an interconnect width (length in the X direction) of the gate electrode 111. More specifically, the coupling portion 111a is provided at the end portion of the gate electrode 111 extending in the Y direction so that both sides protrude in the X direction. Note that a shape of the coupling portion 111a is arbitrary. The width of the coupling portion 111a in the X direction may be the same as the interconnect width of the gate electrode 111. In other words, the coupling portion 111a may be eliminated.

### 1.3.3.2 Decoupling capacitor

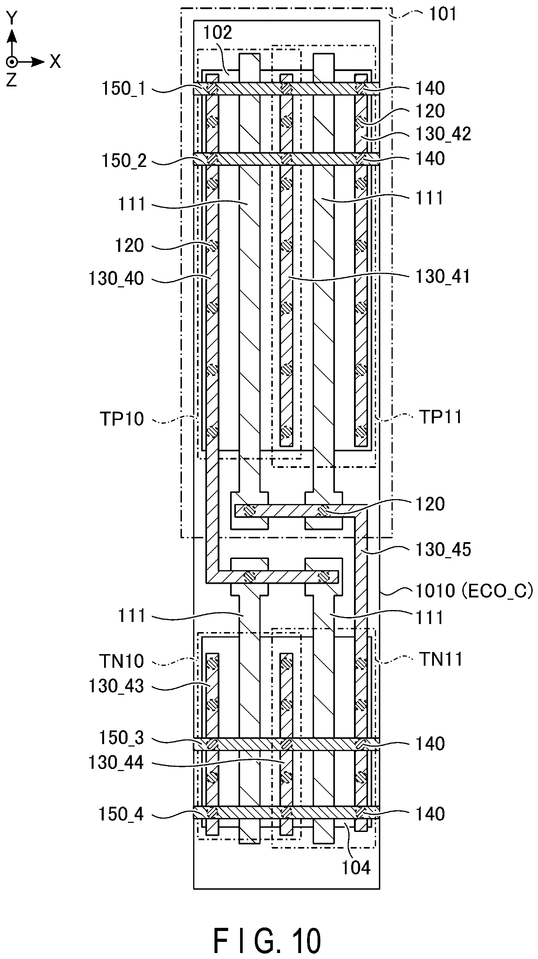

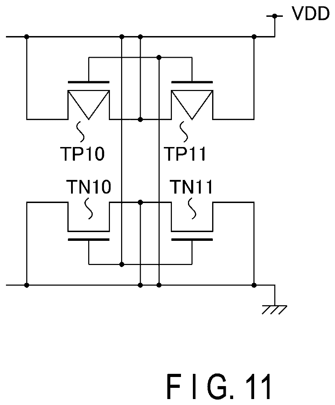

Next, an example of a planar configuration of the ECO base cell 1010 (ECO_C) in which the decoupling capacitor is configured will be described with reference to FIGS. 10 and 11. FIG. 10 is a plan view of the ECO base cell 1010 (ECO_C) in which the decoupling capacitor is configured. FIG. 11 is an equivalent circuit diagram of the ECO base cell 1010 (ECO_C) in which the decoupling capacitor is configured. In the example of FIG. 10, the interlayer insulating film is omitted.

As illustrated in FIG. 10, one end of the PMOS transistor TP10 and the gate electrodes 111 of the NMOS transistors TN10 and TN11 are commonly coupled to the M2 interconnects 150_1 and 150_2 (power supply voltage interconnects) via an M1 interconnect 130_40.

One end shared by the PMOS transistors TP10 and TP11 (the other ends of the PMOS transistors TP10 and TP11) is commonly coupled to the M2 interconnects 150_1 and 150_2 (power supply voltage interconnects) via an M1 interconnect 130_41.

One end of the PMOS transistor TP11 is coupled to the M2 interconnects 150_1 and 150_2 (power supply voltage interconnects) via an M1 interconnect 130_42.

One end of the NMOS transistor TN10 is coupled to the M2 interconnects 150_3 and 150_4 (ground voltage interconnects) via an M1 interconnect 130_43.

One end shared by the NMOS transistors TN10 and TN11 (the other ends of the NMOS transistors TN10 and TN11) is commonly coupled to the M2 interconnects 150_3 and 150_4 (ground voltage interconnects) via an M1 interconnect 130_44.

One end of the NMOS transistor TN11 and the gate electrodes 111 of the PMOS transistors TP10 and TP11 are commonly coupled to the M2 interconnects 150_3 and 150_4 (ground voltage interconnects) via an M1 interconnect 130_45.

As illustrated in FIG. 11, the power supply voltage VDD is applied to the source and the drain of each of the PMOS transistors TP10 and TP11. The gate of each of the PMOS transistors TP10 and TP11 is grounded (the ground voltage VSS is applied). The source and the drain of each of the NMOS transistors TN10 and TN11 are grounded. The power supply voltage VDD is applied to the gate of each of the NMOS transistors TN10 and TN11. As a result, each transistor functions as the decoupling capacitor between the power supply voltage VDD and the ground voltage VSS.

### 1.3.3.3 NAND circuit

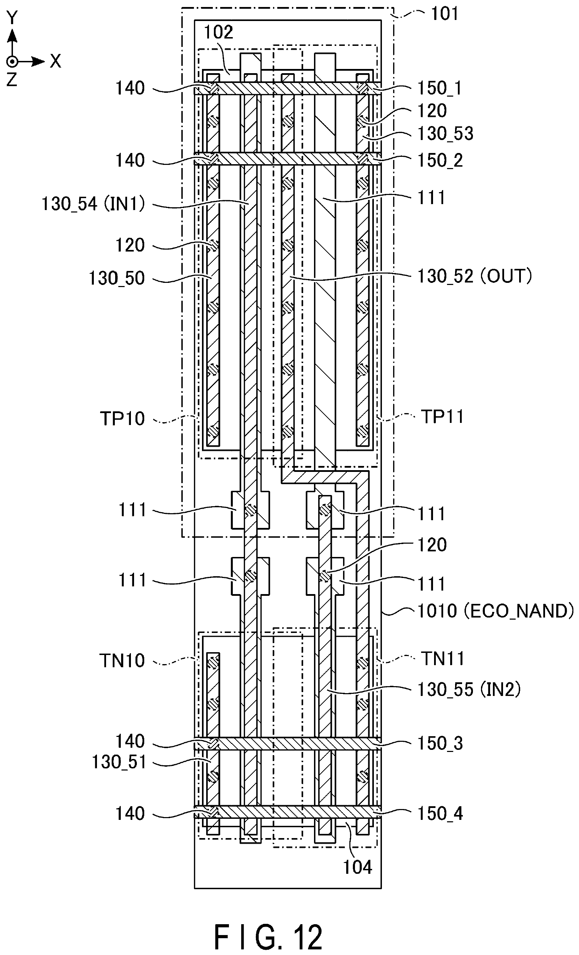

Next, an example of a planar configuration of an ECO base cell 1010 (ECO_NAND) in which the NAND circuit is configured will be described with reference to FIG. 12. FIG. 12 is a plan view of the ECO base cell 1010 (ECO_NAND) in which the NAND circuit is configured. In the example of FIG. 12, the interlayer insulating film is omitted.

As illustrated in FIG. 12, one end of the PMOS transistor TP10 is coupled to the M2 interconnects 150_1 and 150_2 (power supply voltage interconnects) via an M1 interconnect 130_50.

One end of the NMOS transistor TN10 is coupled to the M2 interconnects 150_3 and 150_4 (ground voltage interconnects) via an M1 interconnect 130_51.

One end shared by the PMOS transistors TP10 and TP11 (the other ends of the PMOS transistors TP10 and TP11) and one end of the NMOS transistor TN11 are commonly coupled via an M1 interconnect 130_52. The M1 interconnect 130_52 functions as a signal output interconnect (OUT) of the NAND circuit.

One end shared by the NMOS transistors TN10 and TN11 (the other ends of the NMOS transistors TN10 and TN11) is not coupled to the M1 interconnect 130.

One end of the PMOS transistor TP11 is coupled to the M2 interconnects 150_1 and 150_2 (power supply voltage interconnects) via an M1 interconnect 130_53.

The gate electrode 111 of the PMOS transistor TP10 and the gate electrode 111 of the NMOS transistor TN10 are commonly coupled via an M1 interconnect 130_54. The M1 interconnect 130_54 functions as one signal input interconnect (IN1) of the NAND circuit.

The gate electrode 111 of the PMOS transistor TP11 and the gate electrode 111 of the NMOS transistor TN11 are commonly coupled via an M1 interconnect 130_55. The M1 interconnect 130_55 functions as the other signal input interconnect (IN2) of the NAND circuit.

### 1.3.3.4 NOR circuit

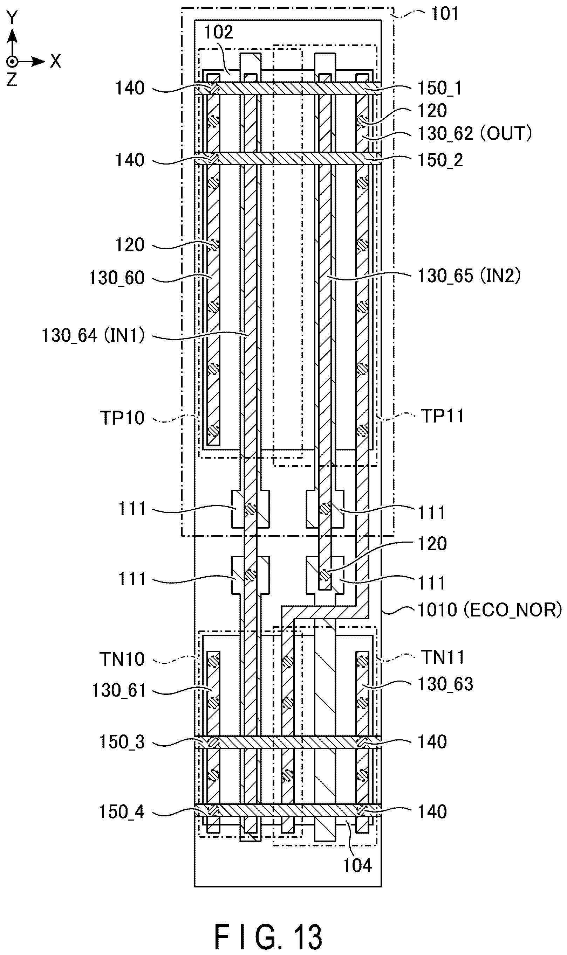

Next, an example of a planar configuration of an ECO base cell 1010 (ECO_NOR) in which the NOR circuit is configured will be described with reference to FIG. 13. FIG. 13 is a plan view of the ECO base cell 1010 (ECO_NOR) in which the NOR circuit is configured. In the example of FIG. 13, the interlayer insulating film is omitted.

As illustrated in FIG. 13, one end of the PMOS transistor TP10 is coupled to the M2 interconnects 150_1 and 150_2 (power supply voltage interconnects) via an M1 interconnect 130_60.

One end of the NMOS transistor TN10 is coupled to the M2 interconnects 150_3 and 150_4 (ground voltage interconnects) via an M1 interconnect 130_61.

One end shared by the PMOS transistors TP10 and TP11 (the other ends of the PMOS transistors TP10 and TP11) is not coupled to the M1 interconnect 130.

One end of the PMOS transistor TP11 and one end shared by the NMOS transistors TN10 and TN11 (the other ends of the NMOS transistors TN10 and TN11) are commonly coupled via an M1 interconnect 130_62. The M1 interconnect 130_62 functions as a signal output interconnect (OUT) of the NOR circuit.

One end of the NMOS transistor TN11 is coupled to the M2 interconnects 150_3 and 150_4 (ground voltage interconnects) via an M1 interconnect 130_63.

The gate electrode 111 of the PMOS transistor TP10 and the gate electrode 111 of the NMOS transistor TN10 are commonly coupled via an M1 interconnect 130_64. The M1 interconnect 130_64 functions as one signal input interconnect (IN1) of the NOR circuit.

The gate electrode 111 of the PMOS transistor TP11 and the gate electrode 111 of the NMOS transistor TN11 are commonly coupled via an M1 interconnect 130_65. The M1 interconnect 130_65 functions as the other signal input interconnect (IN2) of the NOR circuit.

### 1.3.3.5 Inverter circuit

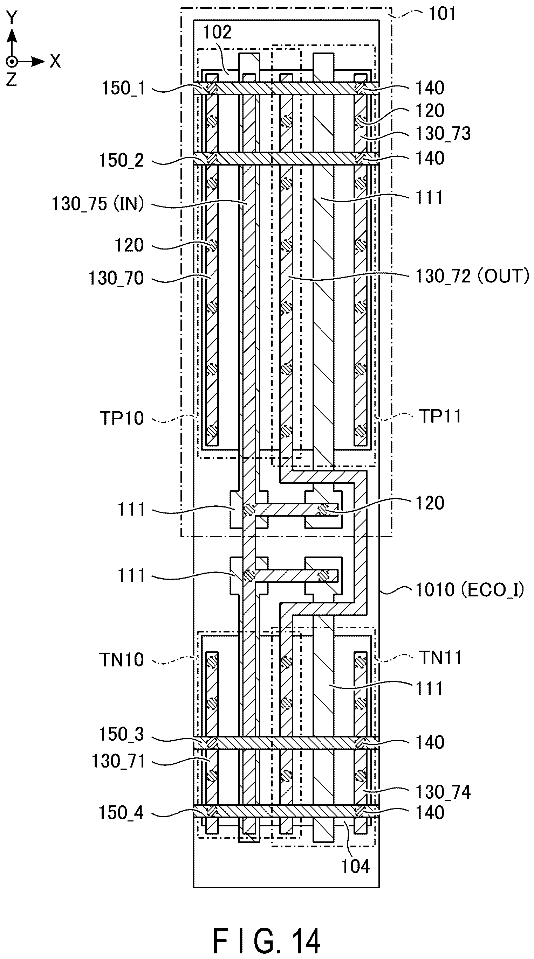

Next, an example of a planar configuration of an ECO base cell 1010 (ECO_I) in which the inverter circuit is configured will be described with reference to FIG. 14. FIG. 14 is a plan view of the ECO base cell 1010 (ECO_I) in which the inverter circuit is configured. In the example of FIG. 14, the interlayer insulating film is omitted.

As illustrated in FIG. 14, one end of the PMOS transistor TP10 is coupled to the M2 interconnects 150_1 and 150_2 (power supply voltage interconnects) via an M1 interconnect 130_70.

One end of the NMOS transistor TN10 is coupled to the M2 interconnects 150_3 and 150_4 (ground voltage interconnects) via an M1 interconnect 130_71.

One end shared by the PMOS transistors TP10 and TP11 (the other ends of the PMOS transistors TP10 and TP11) is commonly coupled to one end shared by the NMOS transistors TN10 and TN11 (the other ends of the NMOS transistors TN10 and TN11) via an M1 interconnect 130_72. The M1 interconnect 130_72 functions as a signal output interconnect (OUT) of the inverter circuit.

One end of the PMOS transistor TP11 is coupled to the M2 interconnects 150_1 and 150_2 (power supply voltage interconnects) via an M1 interconnect 130_73.

One end of the NMOS transistor TN11 is coupled to the M2 interconnects 150_3 and 150_4 (ground voltage interconnects) via an M1 interconnect 130_74.

The gate electrodes 111 of the PMOS transistors TP10 and TP11 and the gate electrodes 111 of the NMOS transistors TN10 and TN11 are commonly coupled via an M1 interconnect 130_75. The M1 interconnect 130_75 functions as a signal input interconnect (IN) of the inverter circuit.

### 1.3.3.6 Buffer circuit

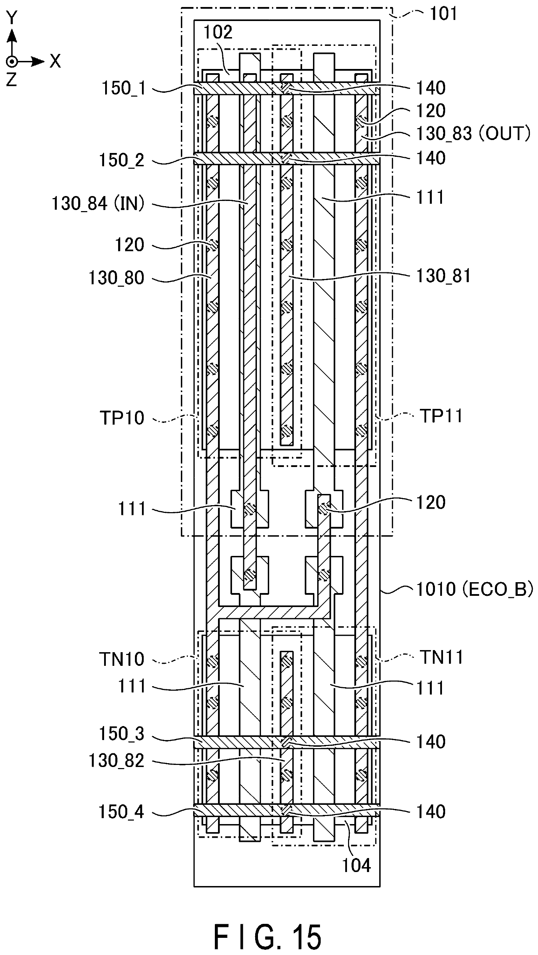

Next, an example of a planar configuration of an ECO base cell 1010 (ECO_B) in which the buffer circuit is configured will be described with reference to FIG. 15. FIG. 15 is a plan view of the ECO base cell 1010 (ECO_B) in which the buffer circuit is configured. In the example of FIG. 15, the interlayer insulating film is omitted.

As illustrated in FIG. 15, one end of the PMOS transistor TP10, one end of the NMOS transistor TN10, the gate electrode 111 of the PMOS transistor TP11, and the gate electrode 111 of the NMOS transistor TN11 are commonly coupled via an M1 interconnect 130_80.

One end shared by the PMOS transistors TP10 and TP11 (the other ends of the PMOS transistors TP10 and TP11) is coupled to the M2 interconnects 150_1 and 150_2 (power supply voltage interconnects) via an M1 interconnect 130_81.

One end shared by the NMOS transistors TN10 and TN11 (the other ends of the NMOS transistors TN10 and TN11) is coupled to the M2 interconnects 150_3 and 150_4 (ground voltage interconnects) via an M1 interconnect 130_82.

One end of the PMOS transistor TP11 and one end of the NMOS transistor TN11 are commonly coupled via an M1 interconnect 130_83. The M1 interconnect 130_83 functions as a signal output interconnect (OUT) of the buffer circuit.

The gate electrode 111 of the PMOS transistor TP10 and the gate electrode 111 of the NMOS transistor TN10 are commonly coupled via an M1 interconnect 130_84. The M1 interconnect 130_84 functions as a signal input interconnect (IN) of the buffer circuit.

### 1.3.3.7 Through cell

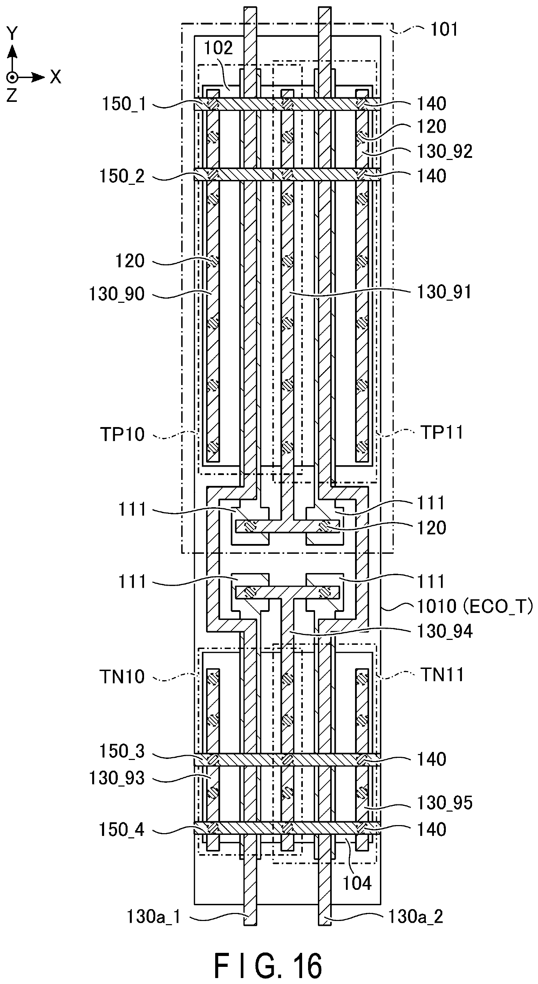

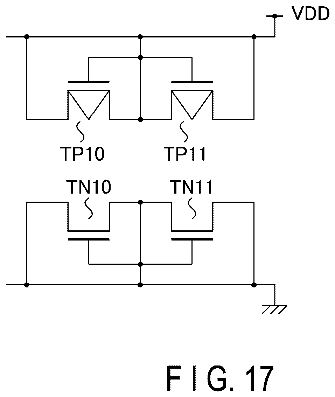

Next, an example of a planar configuration of an ECO base cell 1010 (ECO_T) in which the through cell is configured will be described with reference to FIGS. 16 and 17. FIG. 16 is a plan view of the ECO base cell 1010 (ECO_T) in which the through cell is configured. FIG. 17 is an equivalent circuit diagram of the through cell. In the example of FIG. 16, the interlayer insulating film is omitted. In the example of FIG. 16, a case where two M1 interconnects 130a (130a_1 and 130a_2) passing through the through cell in the Y direction are provided will be described. The M1 interconnects 130a are not electrically coupled to the through cell. Note that the number of M1 interconnects 130a may be one.

As illustrated in FIG. 16, one end of the PMOS transistor TP10 is coupled to the M2 interconnects 150_1 and 150_2 (power supply voltage interconnects) via an M1 interconnect 130_90.

One end shared by the PMOS transistors TP10 and TP11 (the other ends of the PMOS transistors TP10 and TP11), the gate electrode 111 of the PMOS transistor TP10, and the gate electrode 111 of the PMOS transistor TP11 are coupled to the M2 interconnects 150_1 and 150_2 (power supply voltage interconnects) via an M1 interconnect 130_91.

One end of the PMOS transistor TP11 is coupled to the M2 interconnects 150_1 and 150_2 (power supply voltage interconnects) via an M1 interconnect 130_92.

One end of the NMOS transistor TN10 is coupled to the M2 interconnects 150_3 and 150_4 (ground voltage interconnects) via an M1 interconnect 130_93.

One end shared by the NMOS transistors TN10 and TN11 (the other ends of the NMOS transistors TN10 and TN11), the gate electrode 111 of the NMOS transistor TN10, and the gate electrode 111 of the NMOS transistor TN11 are coupled to the M2 interconnects 150_3 and 150_4 (ground voltage interconnects) via an M1 interconnect 130_94.

One end of the NMOS transistor TN11 is coupled to the M2 interconnects 150_3 and 150_4 (ground voltage interconnects) via an M1 interconnect 130_95.

Between the M1 interconnect 130_90 and the M1 interconnect 130_91 and between the M1 interconnect 130_93 and the M1 interconnect 130_94, the M1 interconnect 130a_1 passing through the through cell in the Y direction is disposed. The M1 interconnect 130a_1 is not electrically coupled to each transistor of the through cell. The M1 interconnect 130a_1 passes above the N-type well region 101, the active area 102, the element isolation region STI surrounding the active area 102, the active area 104, the element isolation region STI surrounding the active area 104, the gate electrode 111 of the PMOS transistor TP10, and above the gate electrode 111 of the NMOS transistor TN10 in the Y direction.

Between the M1 interconnect 130_91 and the M1 interconnect 130_92 and between the M1 interconnect 130_94 and the M1 interconnect 130_95, the M1 interconnect 130a_2 passing through the through cell in the Y direction is disposed. The M1 interconnect 130a_2 is not electrically coupled to each transistor of the through cell. The interconnect 130a_2 passes above the N-type well region 101, the active area 102, the element isolation region STI surrounding the active area 102, the active area 104, the element isolation region STI surrounding the active area 104, the gate electrode 111 of the PMOS transistor TP11, and above the gate electrode 111 of the NMOS transistor TN11 in the Y direction.

As illustrated in FIG. 17, the power supply voltage VDD is applied to the gate, the source, and the drain of each of the PMOS transistors TP10 and TP11. The gate, source, and drain of each of the NMOS transistors TN10 and TN11 are grounded. As a result, the potential of each terminal of the transistor is fixed.

### 1.3.4 Planar configuration of fill cell

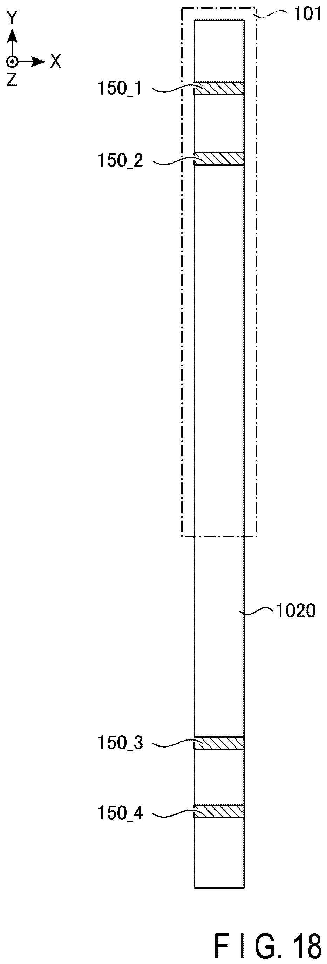

Next, an example of a planar configuration of the fill cell will be described with reference to FIG. 18. FIG. 18 is a plan view of the fill cell. Hereinafter, differences from the standard cell and the ECO base cell will be mainly described.

As illustrated in FIG. 18, a fill cell 1020 includes an N-type well region 101 and M2 interconnects 150_1 to 105_4. Positions of the N-type well region 101 and the M2 interconnects 150_1 to 150_4 in the Y direction are similar to those in the standard cell 1001. The fill cell 1020 does not include a transistor. The N-type well region 101 and the M2 interconnects 150_1 to 105_4 of the fill cell 1020 are coupled to the N-type well region 101 and the M2 interconnects 150_1 to 105_4 of a cell (not illustrated) adjacent in the X direction.

### 1.3.5 Specific examples of using through cell

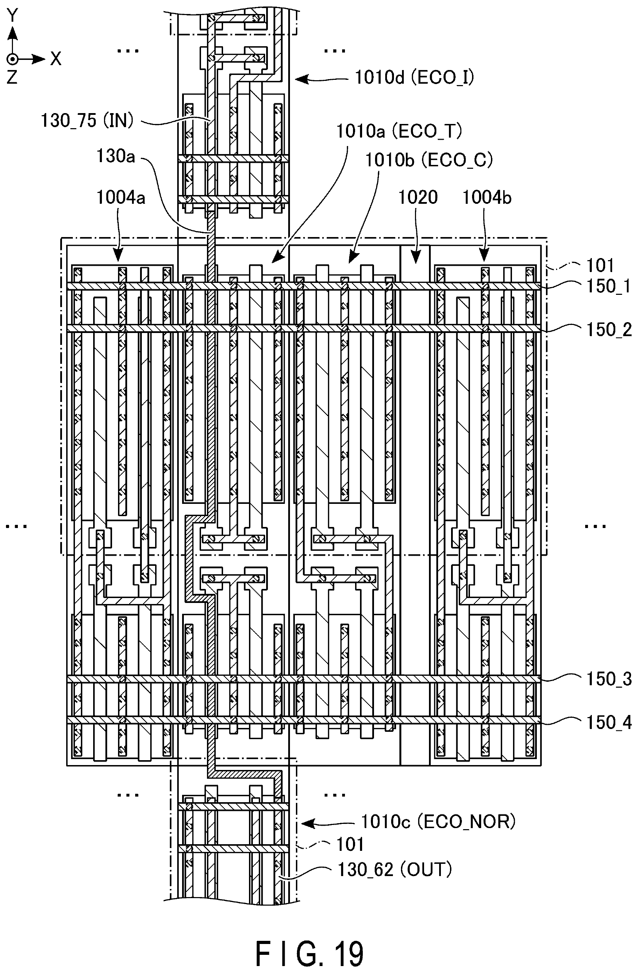

Next, a specific example of using the through cell will be described with reference to FIG. 19. FIG. 19 is a plan view illustrating a specific example of using the through cell in the semiconductor device according to the first embodiment. In the example of FIG. 19, the interlayer insulating film, M3 interconnect 170, M4 interconnect 190, and contact plugs 160 and 180 are omitted.

As illustrated in FIG. 19, for example, a standard cell 1004a of the buffer circuit, ECO base cells 1010a and 1010b, a fill cell 1020, and a standard cell 1004b of the buffer circuit are adjacently placed along the X direction by the automatic place and route. The N-type well regions 101 of the cells placed in the X direction are coupled to each other. Similarly, the M2 interconnects 150_1 to 150_4 of the cells placed in the X direction are coupled to each other. ECO base cells 1010c and 1010d are placed adjacent to each other so as to sandwich the ECO base cell 1010a along the Y direction from the lower side of the drawing sheet.

In a case where the metal ECO is not used, in the ECO base cells 1010a to 1010d, the decoupling capacitor is configured in order to fix the potential of each terminal of the transistor.

In the above layout, a case where an OR (logical sum) circuit using the ECO base cells 1010a, 1010c, and 1010d is configured by the metal ECO will be described.

For example, a through cell is configured by the metal ECO in the ECO base cell 1010a. In the ECO base cell 1010c, a NOR circuit is configured. In the ECO base cell 1010d, an inverter circuit is configured. Then, the M1 interconnect 130_62 of the ECO base cell 1010c (ECO_NOR) and the M1 interconnect 130_75 of the ECO base cell 1010d (ECO_I) are electrically coupled via the M1 interconnect 130a of the ECO base cell 1010a (ECO_T) which is a through cell. That is, an OR circuit is configured by coupling the signal output interconnect of the NOR circuit and the signal input interconnect of the inverter circuit.

### 1.4 Method for manufacturing semiconductor device

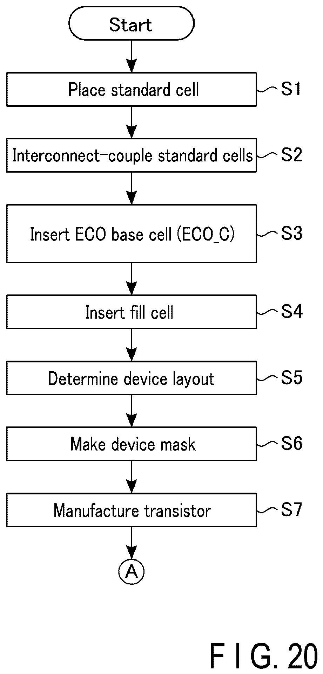

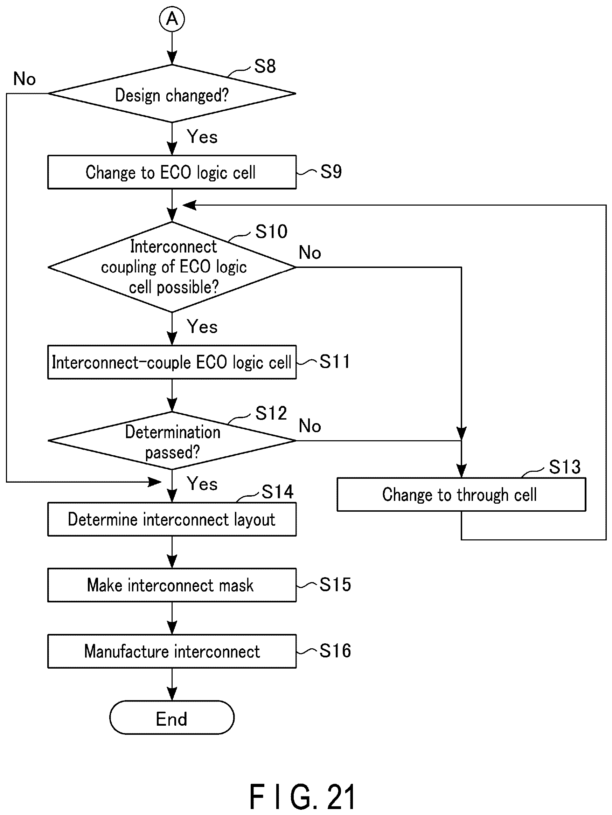

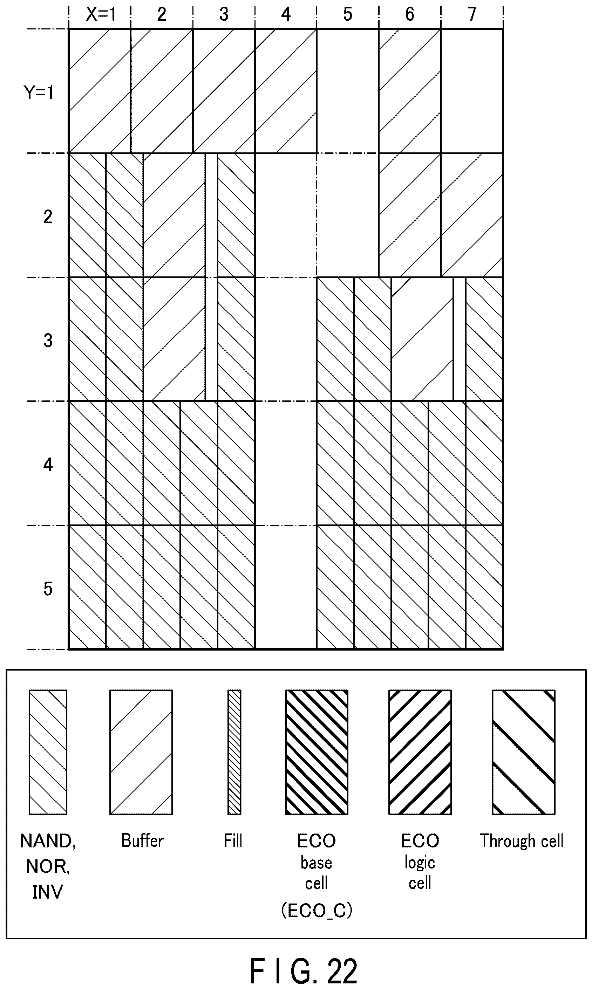

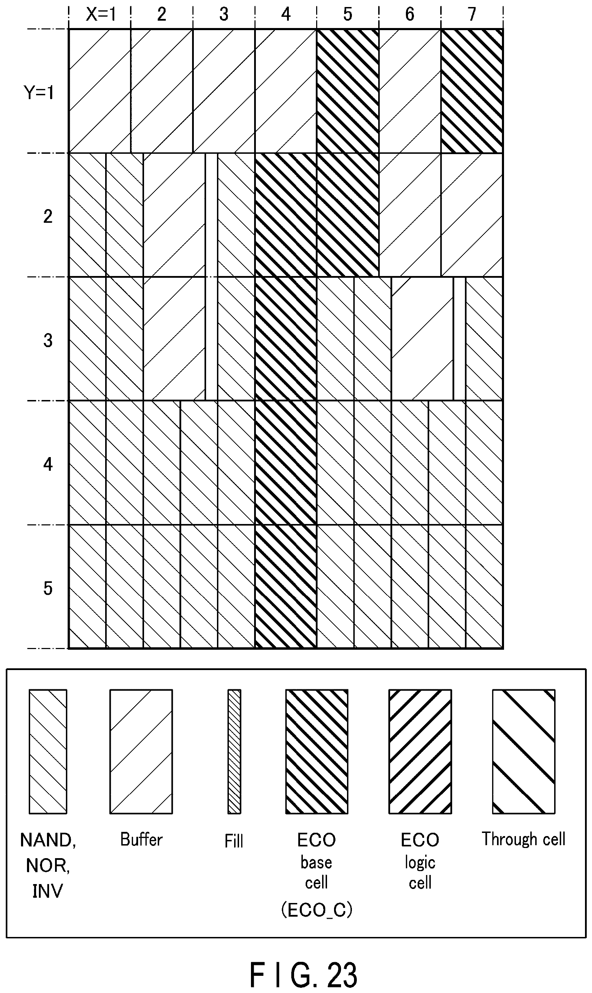

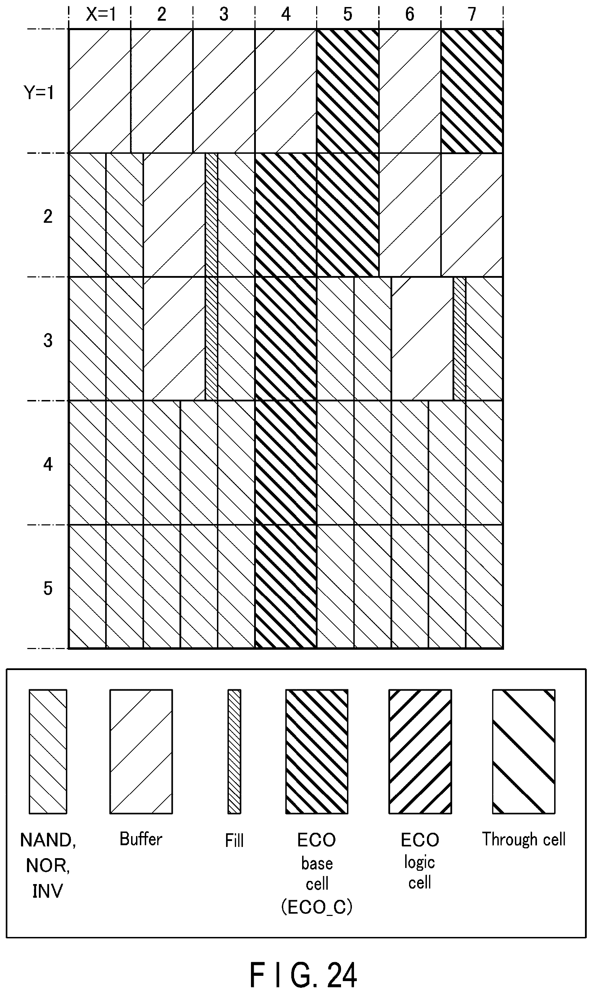

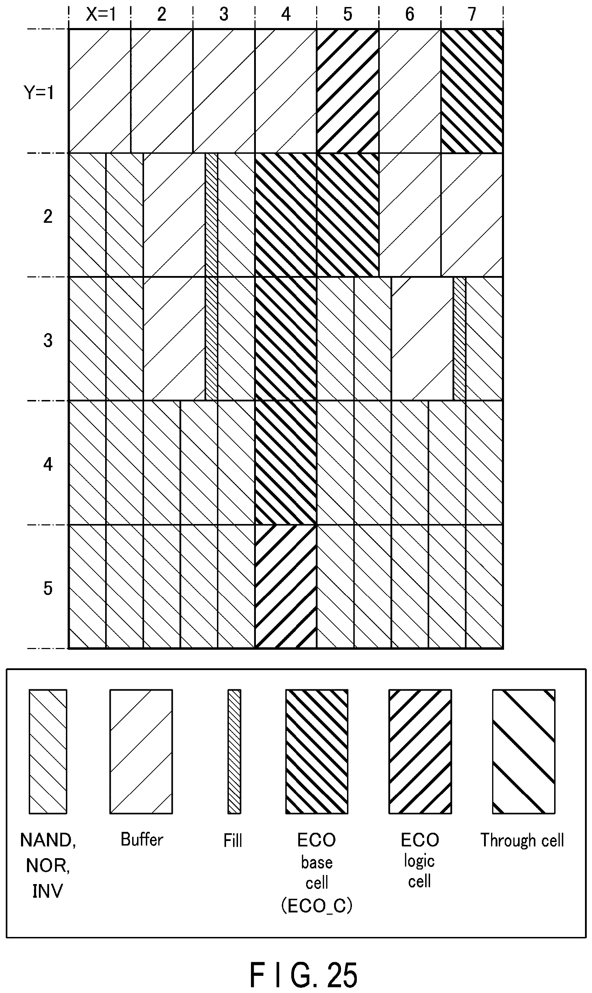

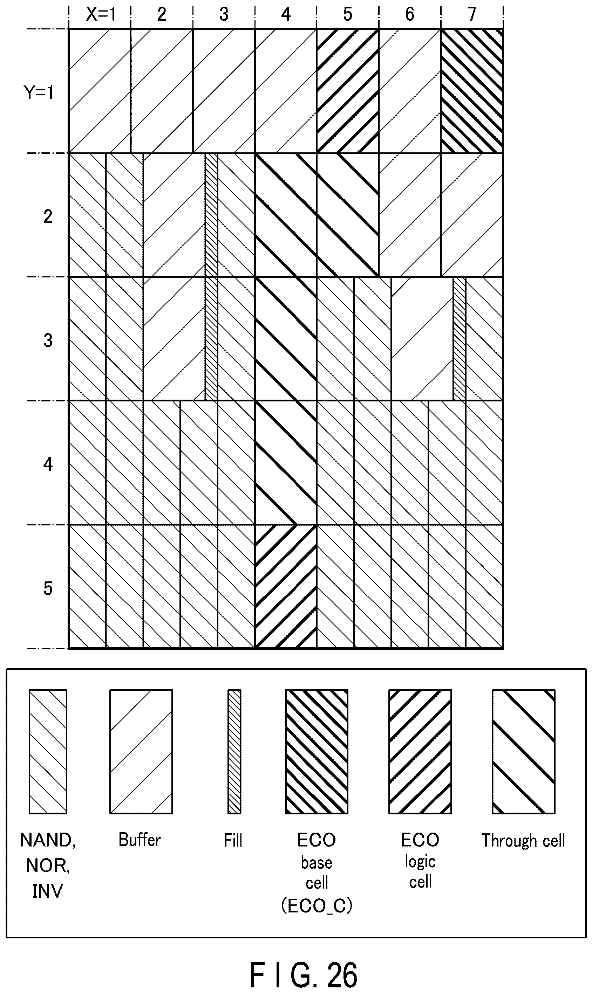

Next, an example of a flow of a method for manufacturing a semiconductor device will be described with reference to FIGS. 20 to 26. FIGS. 20 and 21 are flowcharts of the method for manufacturing a semiconductor device. FIG. 22 is an example of a planar layout after standard cell placement. FIG. 23 is an example of the planar layout after placement of the ECO base cell 1010 (ECO_C) in which the decoupling capacitor is configured. FIG. 24 is an example of the planar layout after the fill cell 1020 is placed. FIG. 25 is an example of the planar layout after change of the ECO logic cell. FIG. 26 is an example of the planar layout after change to the through cell. In the examples of FIGS. 22 to 26, in order to describe the placement position of each cell, grids of 5 rows (Y = 5) ×7 columns (X = 7) based on a cell size of the standard cell 1004 of the buffer circuit are illustrated. A position of each grid is indicated by coordinates (X, Y). Furthermore, in the examples of FIGS. 22 to 26, the standard cell 1001 of the NAND circuit, the standard cell 1002 of the NOR circuit, and the standard cell 1003 of the inverter circuit have the same cell size and are indicated by the same hatching, for simplification of the description. The cell sizes of the standard cell 1004 of the buffer circuit and the ECO base cell are indicated in the same cell size. Note that, in the examples of FIGS. 22 to 26, hatching is appropriately added to the plan view for easy viewing of each cell. The hatching added to the plan view is not related to a material or a characteristic of the component to which the hatching is added.

Hereinafter, a layout design and processes up to interconnect formation in semiconductor device manufacturing processes will be mainly described.

As illustrated in FIG. 20, after circuit design, first, a layout design as illustrated in S1 to S5 is executed. More specifically, first, standard cells are placed based on circuit design data (S1). This step corresponds to "Place" in the automatic place and route.

As illustrated in FIG. 22, in step S1 in which the standard cells are placed, blank regions (region in which no cell is placed) remain on the planar layout. In the example of FIG. 22, regions of coordinates (4, 2), (4, 3), (4, 4), (4, 5), (5, 1), (5, 2), and (7, 1) are blank. Further, a part of the regions of the coordinates (3, 2), (3, 3), and (7, 3) is blank.

As illustrated in FIG. 20, the standard cells are coupled using the M3 interconnects 170 and the M4 interconnects 190 (S2). This step corresponds to "Route" in the automatic place and route.

The ECO base cells 1010 (ECO_C) in which the decoupling capacitor is configured are inserted into the gap regions after the standard cells are placed (S3).

As illustrated in FIG. 23, according to S3, for example, the ECO base cells 1010 (ECO_C) are placed on the planar layout in the regions of the coordinates (4, 2), (4, 3), (4, 4), (4, 5), (5, 1), (5, 2), and (7, 1). Four ECO base cells (ECO_C) are placed adjacent to each other in the Y direction at X = 4, two ECO base cells 1010 (ECO_C) are placed adjacent to each other in the Y direction at X = 5, and an ECO base cell (ECO_C) is placed alone at X = 7. Further, two ECO base cells 1010 (ECO_C) are placed adjacent to each other in the X direction at Y = 2. That is, two or more ECO base cells 1010 (ECO_C) are placed adjacent to each other in the X direction or the Y direction.

As illustrated in FIG. 20, the fill cells 1020 are inserted into the gap regions after the standard cells and the ECO base cells 1010 (ECO_C) are placed (S4).

As illustrated in FIG. 24, according to S4, for example, the fill cells 1020 are placed on the planar layout in blank portions in the regions of the coordinates (3, 2), (3, 3), and (7, 3).

As illustrated in FIG. 20, a device layout is determined (S5). That is, the placement of each cell (transistor) is determined.

Once the device layout is determined, semiconductor device manufacturing processes as shown in S6 to S7 are executed. Note that, in the present example, a case where layout design processes S8 to S14 as will be described later are executed after the semiconductor device manufacturing processes S6 to S7 will be described, but the present invention is not limited thereto. The process for manufacturing a semiconductor device of S6 to S7 and the process of layout design of S8 to S14 may be executed in parallel. First, various masks (hereinafter, referred to as "device masks") related to a photolithography process of the element isolation regions and well regions (diffusion layer regions) of the semiconductor substrate 100 and the transistors are made (S6).

The transistors are manufactured on the semiconductor substrate 100 based on the device mask (S7).

As illustrated in FIG. 21, the layout design (metal ECO) as illustrated in S8 to S14 is executed. When there is a change in circuit design (S8_Yes), the metal ECO is executed. More specifically, the configuration of some ECO base cells 1010 is changed from decoupling capacitors to ECO logic cells (S9). That is, the layout of the interconnect layer (here, the M1 interconnect 130) of the ECO base cell 1010 is changed.

As illustrated in FIG. 25, according to S9, for example, the ECO base cells of the coordinates (4, 5) and (5, 1) are changed to ECO logic cells on the planar layout.

As illustrated in FIG. 21, it is confirmed whether interconnect coupling of the ECO logic cell is possible (S10). More specifically, in the layout of the M2 interconnect 150, the M3 interconnect 170, and the M4 interconnect 190, it is confirmed whether there is a space for providing the M3 interconnect 170 and the M4 interconnect 190 coupled to the ECO logic cell.

When the interconnect coupling of the ECO logic cell is possible (S10_Yes), the ECO logic cell is coupled using the M2 interconnect 150, the M3 interconnect 170, and the M4 interconnect 190 (S11). The ECO logic cells may be coupled to each other, or the ECO logic cell and the standard cell may be coupled to each other.

Layout check of the interconnect is executed (S12). For example, in a case where congestion degrees of the M3 interconnects 170 and the M4 interconnects 190 are high, there is a case where the interconnect coupled to the ECO logic cell may not satisfy a design rule or a condition such as a signal transmission timing.

When the interconnect coupling of the ECO logic cell cannot be performed (S10_No) or when the determination of the layout check has not been passed (S12_No), the metal ECO is executed again. More specifically, an unused ECO base cell 1010 (ECO_C) that has not been changed to the ECO logic cell is searched in the vicinity of the ECO logic cell in which interconnect coupling is impossible or layout check is NG. Then, the configuration of the ECO base cell 1010 (ECO_C) is changed from the decoupling capacitor to the through cell (S13).

As illustrated in FIG. 26, according to S13, for example, in order to couple the ECO logic cells of the coordinates (4, 5) and (5, 1) on the planar layout, the ECO base cells in the regions of the coordinates (4, 2), (4, 3), (4, 4), and (5, 2) are changed to through cells. For example, the through cell is adjacent to the ECO logic cell in the Y direction.

As illustrated in FIG. 21, after the change to the through cell, the process proceeds to S10 to confirm whether the interconnect coupling of the ECO logic cell is possible. When the interconnect coupling is possible (S10_Yes), the interconnect is coupled to the ECO logic cell in which the interconnect coupling is NG, using the M1 interconnect 130a passing through the through cell. In the planar layout illustrated in FIG. 26, the ECO logic cells of the coordinates (4, 5) and (5, 1) are coupled via the through cells of the coordinates (4, 2), (4, 3), (4, 4), and (5, 2).

When the circuit design is not changed (S8_Yes) or when the determination of the layout check has been passed (S12_Yes), the interconnect layout is determined (S14). Thus, the layout design is finished.

Once the interconnect layout is determined, the semiconductor device manufacturing processes as shown in S15 to S16 are executed. First, various masks (hereinafter, referred to as "interconnect masks") related to the photolithography process for interconnect formation are made (S15).

Various interconnects are manufactured based on the interconnect masks (S16). More specifically, for example, the contact plug 120, the M1 interconnect 130, the contact plug 140, the M2 interconnect 150, the contact plug 160, the M3 interconnect 170, the contact plug 180, and the M4 interconnect 190 are sequentially formed.

### 1.5 Effect according to present embodiment

With the configuration according to the present embodiment, it is possible to suppress an increase in development cost and an extension of the development work period. The effects will be described in detail.

For example, the circuit design may be changed after the mask of the semiconductor device 1 is made. In such a case, if the process is re-started from the layout of the transistor, the device mask would be made again, which leads to an increase in development cost and an extension of the development work period.

On the other hand, with the configuration according to the present embodiment, the ECO base cell can be placed in an empty space in which the standard cell is placed in the automatic place and route. The circuit function of the ECO base cell can be changed by changing the layout of the M1 interconnect by the metal ECO. Therefore, even if the circuit design is changed after the device mask is made, it is possible to deal with the circuit design by executing the metal ECO without changing the placement of the cell (transistor).

However, even if the ECO base cell is changed to the ECO logic cell, interconnect coupling to the ECO logic cell may not be possible. In addition, even if the interconnect coupling can be performed, the determination of the layout check cannot be passed in some cases if the interconnect congestion degree due to the interconnect increase accompanying addition of the ECO logic cell is high.

On the other hand, with the configuration according to the present embodiment, the through cell can be configured in the ECO base cell. In the through cell, the M1 interconnect which is not coupled to the transistor in the through cell and couples the cells adjacent to the through cell can be provided. By providing the through cell, a layout resource of the M1 interconnect can be increased. As a result, interconnect congestion can be alleviated, and the metal ECO can be executed. Therefore, by providing the through cell, the interconnect coupling of the ECO logic cell can be made easier. Therefore, only change of the interconnect mask in the interconnect process can deal with the change in circuit design, without changing the device mask corresponding to the semiconductor forming process including the transistor. Therefore, the increase in development cost and the extension of the development work period can be suppressed.

The terminal of the transistor in the through cell is coupled to the power supply voltage interconnect or ground voltage interconnect. Therefore, charges are not accumulated in the terminal of the transistor, which contributes to a stable operation.

### 1.6. Modification of first embodiment

Next, a modification of the first embodiment will be described. Hereinafter, differences from the first embodiment will be mainly described.

### 1.6.1 First modification

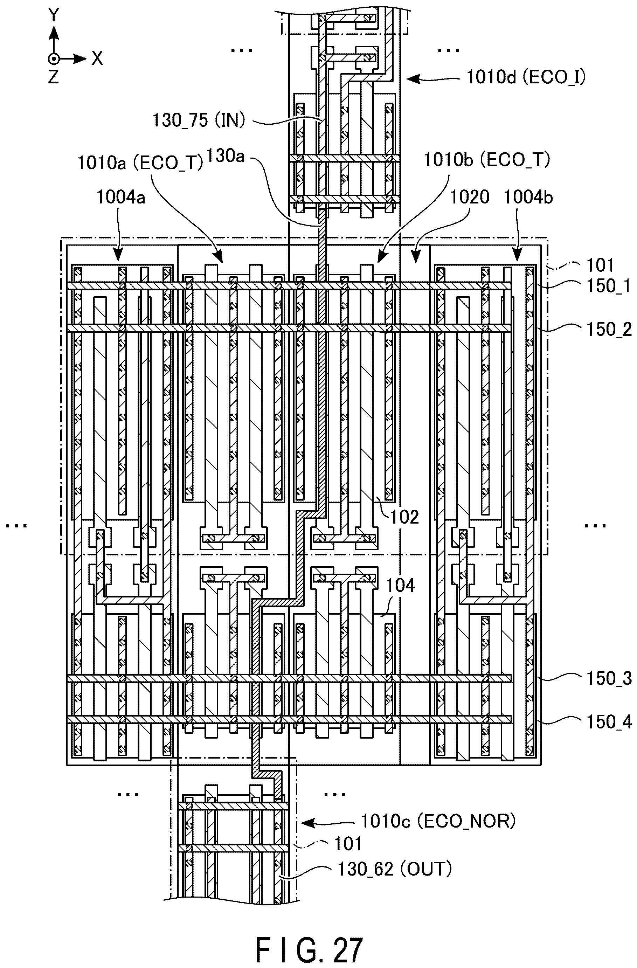

First, a first modification of the first embodiment will be described. In the first modification, a case where an M1 interconnect 130a passing through two through cells placed adjacent to each other in the X direction is provided will be described. FIGS. 27 to 29 are plan views of a semiconductor device 1 illustrating specific examples of using a through cell. The examples of FIGS. 27 to 29 are different in layout of the M1 interconnect 130a. In the examples of FIGS. 27 to 29, the interlayer insulating film, M3 interconnect 170, M4 interconnect 190, and contact plugs 160 and 180 are omitted.

As illustrated in FIG. 27, for example, a standard cell 1004a of the buffer circuit, ECO base cells 1010a and 1010b, a fill cell 1020, and a standard cell 1004b of the buffer circuit are adjacently placed along the X direction by the automatic place and route. ECO base cells 1010c are placed adjacent on the lower side, on the drawing sheet, of the ECO base cell 1010a. ECO base cells 1010d are placed adjacent on the upper side, on the drawing sheet, of the ECO base cell 1010b.

In the above layout, for example, a through cell is configured by the metal ECO in the ECO base cells 1010a and 1010b. In the ECO base cell 1010c, a NOR circuit is configured. In the ECO base cell 1010d, an inverter circuit is configured. Then, an M1 interconnect 130_62 of the ECO base cell 1010c (ECO_NOR) and an M1 interconnect 130_75 of the ECO base cell 1010d (ECO_I) are electrically coupled via the M1 interconnect 130a passing through the ECO base cells 1010a (ECO_T) and 1010b (ECO_T) which are through cells. More specifically, the M1 interconnect 130a passes, in the Y direction, above an N-type well region 101 of the ECO base cell 1010b (ECO_T), an active area 102, an element isolation region STI surrounding the active area 102, and a gate electrode 111 of a PMOS transistor TP10. The M1 interconnect 130a that has passed through the active area 102 in the Y direction is bent in the X direction on the left side of the drawing sheet. Then, in the ECO base cell 1010b (ECO_T), the M1 interconnect 130a is bent and extends in the Y direction on the lower side of the drawing sheet. The M1 interconnect 130a extending in the Y direction is bent in the X direction on the left side of the drawing sheet and extends into the ECO base cell 1010a (ECO_T) before reaching an active area 104 of the ECO base cell 1010b (ECO_T). Further, the M1 interconnect 130a is bent in the Y direction on the lower side of the drawing sheet, and passes above the active area 104 of the ECO base cell 1010a (ECO_T), an element isolation region STI surrounding the active area 104, and a gate electrode 111 of an NMOS transistor TN11 in the Y direction.

Note that the layout of the M1 interconnect 130a is not limited to the above. Two examples of different layouts of the M1 interconnect 130a will be described.

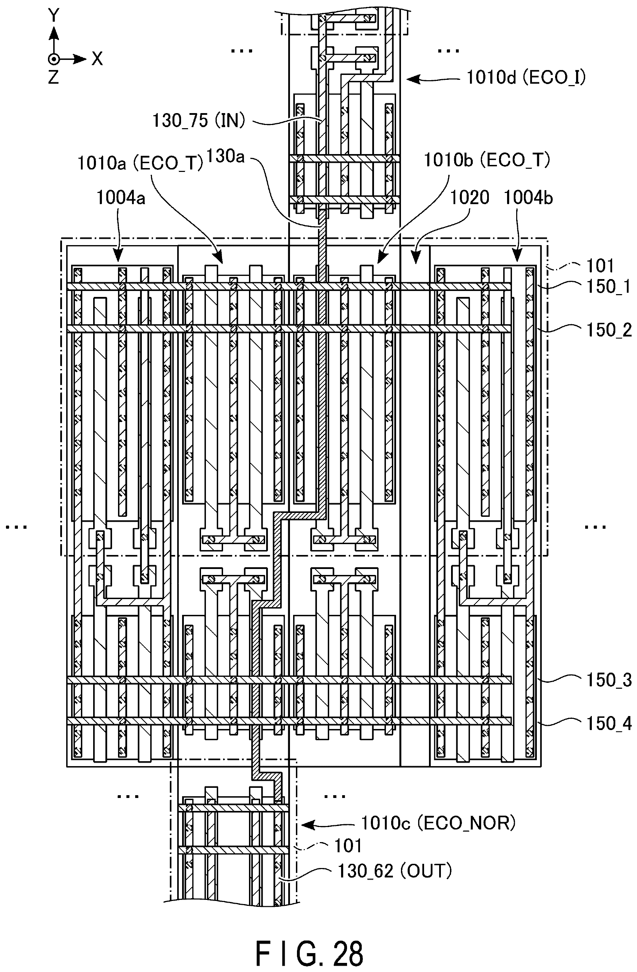

As illustrated in FIG. 28, for example, the M1 interconnect 130a that has passed through the active area 102 of the ECO base cell 1010b (ECO_T) in the Y direction is bent in the X direction on the left side of the drawing sheet, and extends into the ECO base cell 1010a (ECO_T). Then, in the ECO base cell 1010a (ECO_T), the M1 interconnect 130a is bent and extends in the Y direction on the lower side of the drawing sheet. The M1 interconnect 130a extending in the Y direction is bent in the X direction on the left side of the drawing sheet before reaching the active area 104 of the ECO base cell 1010a (ECO_T). The M1 interconnect 130a is bent in the Y direction on the lower side of the drawing sheet, and extends in the Y direction above the gate electrode 111 of the NMOS transistor TN11.

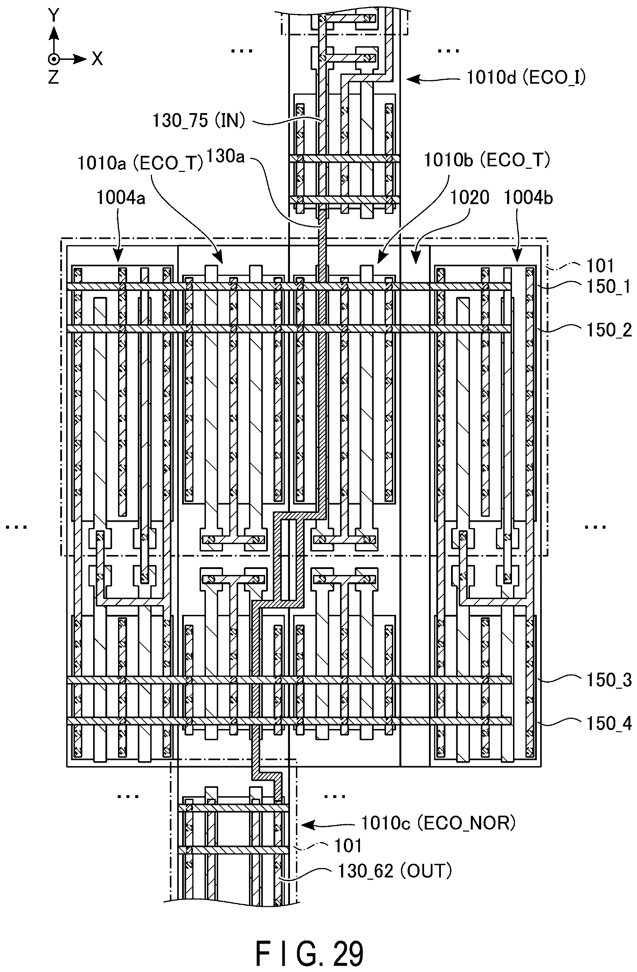

As illustrated in FIG. 29, a part of the M1 interconnect 130a may be branched into two parts. For example, the M1 interconnect 130a that has passed through the active area 102 of the ECO base cell 1010b (ECO_T) in the Y direction is bent in the X direction on the left side of the drawing sheet. The M1 interconnect 130a extending in the X direction is branched into two.

One of the two is bent and extends in the Y direction on the lower side of the drawing sheet in the ECO base cell 1010b (ECO_T) as described with reference to FIG. 27. The M1 interconnect 130a extending in the Y direction is bent in the X direction on the left side of the drawing sheet and extends into the ECO base cell 1010b (ECO_T) before reaching the active area 104 of the ECO base cell 1010b (ECO_T).

The other extends into the ECO base cell 1010a (ECO_T) as described with reference to FIG. 28. Then, in the ECO base cell 1010a (ECO_T), the M1 interconnect 130a is bent and extends in the Y direction on the lower side of the drawing sheet. The M1 interconnects 130a extending in the Y direction merge with one of the branched M1 interconnects 130a before reaching the active area 104 of the ECO base cell 1010a (ECO_T).

### 1.6.2 Second modification

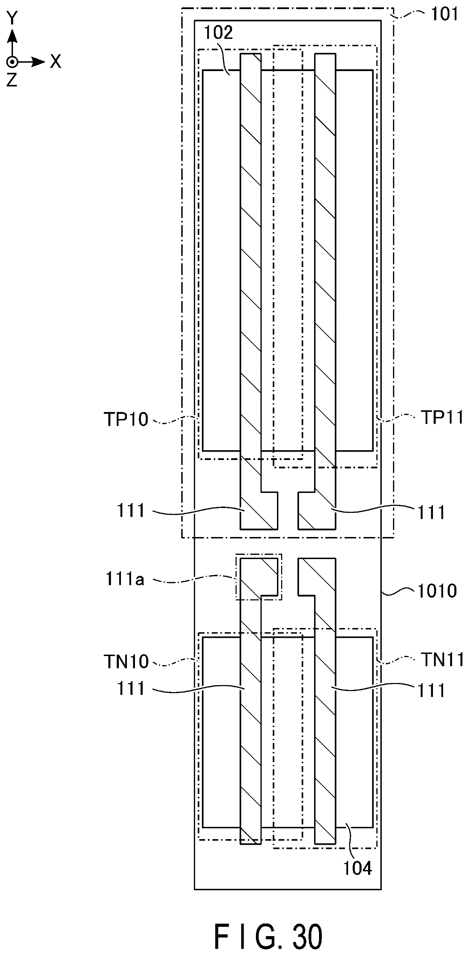

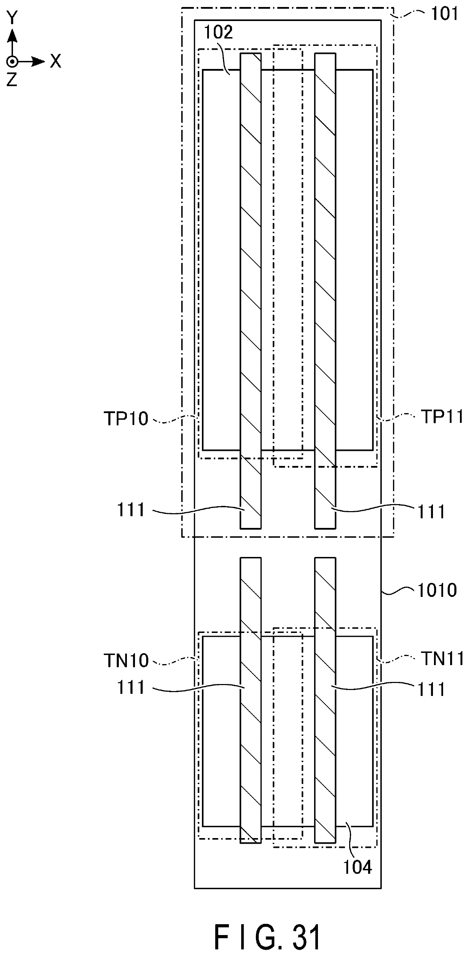

Next, a second modification of the first embodiment will be described. In the second modification, two examples of a structure of a coupling portion 111a of a gate electrode 111 different from that of the first embodiment will be described. FIGS. 30 and 31 are plan views of a transistor of an ECO base cell 1010. In the examples of FIGS. 30 and 31, the interlayer insulating film, M1 interconnect 130, M2 interconnect 150, and contact plugs 120 and 140 are omitted.

As illustrated in FIG. 30, the configuration of each transistor of the ECO base cell 1010 is similar to that in FIG. 9 of the first embodiment.

In the example of FIG. 30, the coupling portion 111a is provided at an end portion of the gate electrode 111 of each transistor. A width of the coupling portion 111a in the X direction is larger than an interconnect width of the gate electrode 111. In the example of FIG. 30, the coupling portion 111a is provided so as to protrude from the gate electrode 111 in one of the X directions.

As illustrated in FIG. 31, the configuration of each transistor of the ECO base cell 1010 is similar to that in FIG. 9 of the first embodiment.

In the example of FIG. 31, the coupling portion 111a is eliminated. In other words, the coupling portion 111a having the same length as the interconnect width of the gate electrode 111 is provided at the end portion of the gate electrode 111.

In the present modification, the coupling portion 111a of the gate electrode 111 of the ECO base cell has been described, but the gate electrode of the standard cell may have a similar structure.

### 1.6.3 Third modification

Next, a third modification of the first embodiment will be described. In the third modification, two examples of a configuration of a through cell different from that of the first embodiment will be described.

### 1.6.3.1 First example of through cell

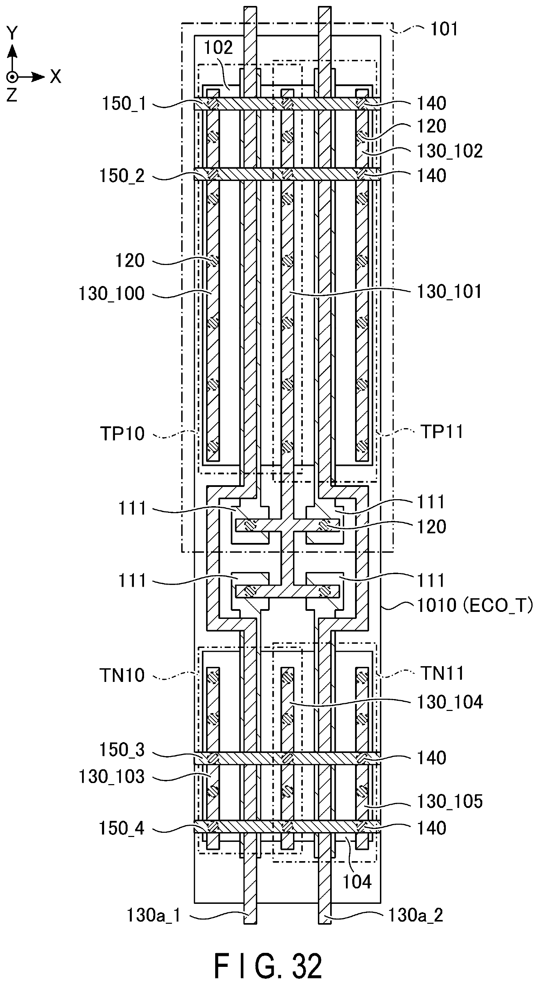

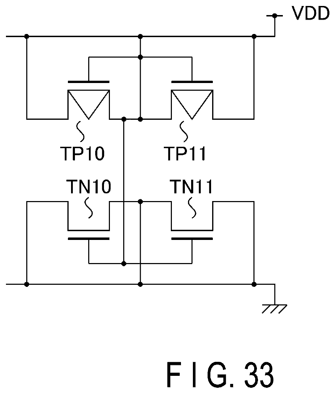

First, an example of a planar configuration of an ECO base cell 1010 (ECO_T) in which a through cell including a decoupling capacitor by an NMOS transistor is configured will be described with reference to FIGS. 32 and 33. FIG. 32 is a plan view of the ECO base cell 1010 (ECO_T) in which the through cell including the decoupling capacitor by the NMOS transistor is configured. FIG. 33 is an equivalent circuit diagram of the through cell including the decoupling capacitor by the NMOS transistor. In the example of FIG. 32, the interlayer insulating film is omitted. In the example of FIG. 32, a case where two M1 interconnects 130a (130a_1 and 130a_2) passing through the through cell in the Y direction are provided will be described. The M1 interconnect 130a is not electrically coupled to each transistor of the through cell. Note that the number of M1 interconnects 130a may be one.

As illustrated in FIG. 32, one end of a PMOS transistor TP10 is coupled to M2 interconnects 150_1 and 150_2 (power supply voltage interconnects) via an M1 interconnect 130_100.

One end shared by PMOS transistors TP10 and TP11 (the other end of the PMOS transistors TP10 and TP11), a gate electrode 111 of the PMOS transistor TP10, a gate electrode 111 of the PMOS transistor TP11, a gate electrode 111 of an NMOS transistor TN10, and a gate electrode 111 of an NMOS transistor TN11 are coupled to the M2 interconnects 150_1 and 150_2 (power supply voltage interconnects) via an M1 interconnect 130_101.

One end of the PMOS transistor TP11 is coupled to the M2 interconnects 150_1 and 150_2 (power supply voltage interconnects) via an M1 interconnect 130_102.

One end of the NMOS transistor TN10 is coupled to the M2 interconnects 150_3 and 150_4 (ground voltage interconnects) via an M1 interconnect 130_103.

One end shared by the NMOS transistors TN10 and TN11 (the other ends of the NMOS transistors TN10 and TN11) is coupled to the M2 interconnects 150_3 and 150_4 (ground voltage interconnects) via an M1 interconnect 130_104.

One end of the NMOS transistor TN11 is coupled to the M2 interconnects 150_3 and 150_4 (ground voltage interconnects) via an M1 interconnect 130_105.

Between the M1 interconnect 130_100 and the M1 interconnect 130_101 and between the M1 interconnect 130_103 and the M1 interconnect 130_104, the M1 interconnect 130a_1 passing through the through cell in the Y direction is disposed. The M1 interconnect 130a_1 is not electrically coupled to each transistor of the through cell.

Between the M1 interconnect 130_101 and the M1 interconnect 130_102 and between the M1 interconnect 130_104 and the M1 interconnect 130_105, the M1 interconnect 130a_2 passing through the through cell in the Y direction is disposed. The M1 interconnect 130a_2 is not electrically coupled to each transistor of the through cell.

As illustrated in FIG. 33, the power supply voltage VDD is applied to the gate, the source, and the drain of each of the PMOS transistors TP10 and TP11. The power supply voltage VDD is applied to the gate of each of the NMOS transistors TN10 and TN11. The source and the drain of each of the NMOS transistors TN10 and TN11 are grounded. As a result, the potential of each terminal of the transistor is fixed. The NMOS transistors TN10 and TN11 function as the decoupling capacitors between the power supply voltage VDD and the ground voltage VSS.

### 1.6.3.2 Second example of through cell

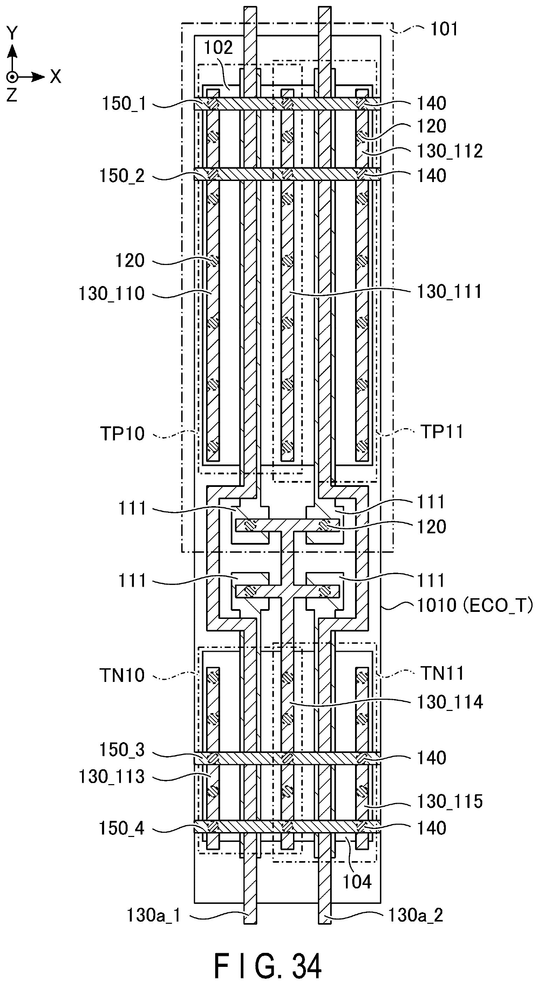

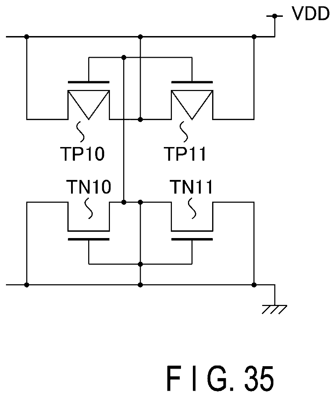

First, an example of a planar configuration of an ECO base cell 1010 (ECO_T) in which a through cell including a decoupling capacitor by a PMOS transistor is configured will be described with reference to FIGS. 34 and 35. FIG. 34 is a plan view of the ECO base cell 1010 (ECO_T) in which the through cell including the decoupling capacitor by the PMOS transistor is configured. FIG. 35 is an equivalent circuit diagram of the through cell including the decoupling capacitor by the PMOS transistor. In the example of FIG. 34, the interlayer insulating film is omitted. In the example of FIG. 34, a case where two M1 interconnects 130a (130a_1 and 130a_2) passing through the through cell in the Y direction are provided will be described. The M1 interconnect 130a is not electrically coupled to each transistor of the through cell. Note that the number of M1 interconnects 130a may be one.

As illustrated in FIG. 34, one end of a PMOS transistor TP10 is coupled to M2 interconnects 150_1 and 150_2 (power supply voltage interconnects) via an M1 interconnect 130_110.

One end shared by the PMOS transistors TP10 and TP11 (the other ends of the PMOS transistors TP10 and TP11) is coupled to the M2 interconnects 150_1 and 150_2 (power supply voltage interconnects) via an M1 interconnect 130_111.

One end of the PMOS transistor TP11 is coupled to the M2 interconnects 150_1 and 150_2 (power supply voltage interconnects) via an M1 interconnect 130_112.

One end of the NMOS transistor TN10 is coupled to the M2 interconnects 150_3 and 150_4 (ground voltage interconnects) via an M1 interconnect 130_113.

One end shared by NMOS transistors TN10 and TN11 (the other end of the NMOS transistors TN10 and TN11), a gate electrode 111 of a PMOS transistor TP10, a gate electrode 111 of a PMOS transistor TP11, a gate electrode 111 of the NMOS transistor TN10, and a gate electrode 111 of the NMOS transistor TN11 are coupled to the M2 interconnects 150_3 and 150_4 (ground voltage interconnects) via an M1 interconnect 130_114.

One end of the NMOS transistor TN11 is coupled to the M2 interconnects 150_3 and 150_4 (ground voltage interconnects) via an M1 interconnect 130_115.

Between the M1 interconnect 130_110 and the M1 interconnect 130_111 and between the M1 interconnect 130_113 and the M1 interconnect 130_114, the M1 interconnect 130a_1 passing through the through cell in the Y direction is disposed. The M1 interconnect 130a_1 is not electrically coupled to each transistor of the through cell.

Between the M1 interconnect 130_111 and the M1 interconnect 130_112 and between the M1 interconnect 130_114 and the M1 interconnect 130_115, the M1 interconnect 130a_2 passing through the through cell in the Y direction is disposed. The M1 interconnect 130a_2 is not electrically coupled to each transistor of the through cell.

As illustrated in FIG. 35, the gate of each of the PMOS transistors TP10 and TP11 is grounded. The power supply voltage VDD is applied to the source and the drain of each of the PMOS transistors TP10 and TP11. The gate, source, and drain of each of the NMOS transistors TN10 and TN11 are grounded. As a result, the potential of each terminal of the transistor is fixed. The PMOS transistors TP10 and TP11 function as the decoupling capacitors between the power supply voltage VDD and the ground voltage VSS.

### 1.6.4 Fourth modification

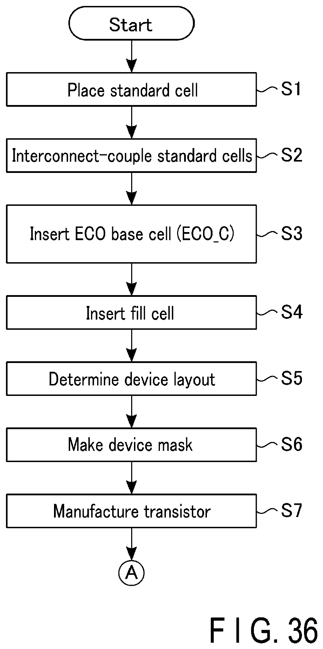

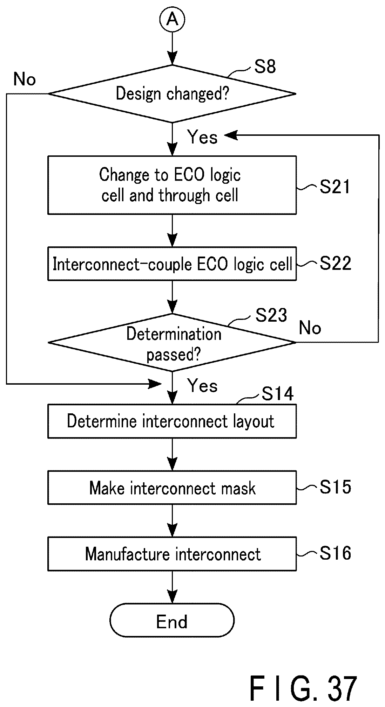

Next, a fourth modification of the first embodiment will be described. In a fourth modification, a method for manufacturing a semiconductor device different from that of the first embodiment will be described. FIGS. 36 and 37 are flowcharts of the method for manufacturing a semiconductor device. Hereinafter, differences from FIGS. 20 and 21 of the first embodiment will be mainly described.

As illustrated in FIG. 36, processes S1 to S7 are similar to those in FIG. 20 of the first embodiment.

As illustrated in FIG. 37, when there is a change in circuit design (S8_Yes), the metal ECO is executed. In this example, the change to the ECO logic cell in S9 and the change to the through cell in S13 described with reference to FIG. 21 are collectively executed (S21). More specifically, according to S21, the planar layout of the semiconductor device 1 is changed from, for example, the planar layout illustrated in FIG. 24 of the first embodiment to the planar layout illustrated in FIG. 26.

Next, the ECO logic cell is coupled using the M1 interconnect 130, the M2 interconnect 150, the M3 interconnect 170, and the M4 interconnect 190 using the through cell (S22).

Layout check of the interconnect is executed (S23). In this example, when the determination of the layout check has not been passed (S23_No), the process proceeds to S21, and the metal ECO is executed again.

When the circuit design is not changed (S8_Yes) or when the determination of the layout check has been passed (S23_Yes), the interconnect layout is determined (S14). Thus, the layout design is finished.

Once the interconnect layout is determined, the semiconductor device manufacturing processes shown in S15 to S16 are executed as in the first embodiment.

### 1.6.5 Effect of modification of first embodiment

The structures according to the modifications of the first embodiment provide the same effects as those of the first embodiment.

The first modification, the second modification, the third modification, and the fourth modification may be combined.

### 2. Second embodiment

Next, a second embodiment will be described. In the second embodiment, a case where the semiconductor device 1 is a NOR flash memory will be described. Hereinafter, differences from the first embodiment will be mainly described.

### 2.1 Overall configuration of semiconductor device

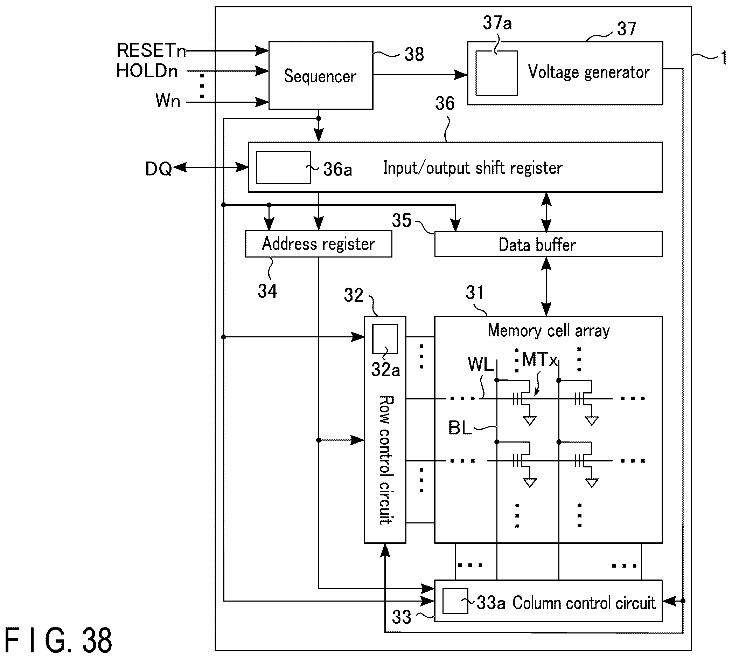

An example of an overall configuration of the semiconductor device 1 will be described with reference to FIG. 38. FIG. 38 is a block diagram illustrating the overall configuration of the semiconductor device 1. In FIG. 38, a part of coupling between components is indicated by an arrow line, but the coupling between the components is not limited thereto.

As illustrated in FIG. 38, the semiconductor device 1 is a NOR flash memory.

The semiconductor device 1 includes a memory cell array 31, a row control circuit 32, a column control circuit 33, an address register 34, a data buffer 35, an input/output shift register 36, a voltage generator 37, and a sequencer 38.

The memory cell array 31 includes a plurality of memory cells (memory cell transistors) MTx. In the semiconductor device 1, a gate of each memory cell MTx is coupled to a corresponding one of a plurality of word lines WL. One end of a current path of each memory cell MTx is coupled to a corresponding one of a plurality of bit lines BL. The other end of the current path of each memory cell MTx is coupled to a source line and, for example, grounded. The memory cells MTx are arranged in a two-dimensional array or a three-dimensional array.

The memory cell MTx is a field effect transistor having a stack gate structure including a charge storage layer. The charge storage layer may be a floating gate electrode or a charge trap film.

The row control circuit 32 selects the word line WL corresponding to address information among the word lines WL. The row control circuit 32 applies a predetermined voltage to the selected word line WL (and the non-selected word lines WL) in a write operation, a read operation, an erase operation, and the like.

The row control circuit 32 includes a digital signal control circuit 32a that processes the received digital signal.

The column control circuit 33 selects the bit line BL corresponding to the address information among the bit lines BL. The row control circuit 32 applies a predetermined voltage to the selected bit line BL (and the non-selected bit lines BL) in the write operation, the read operation, the erase operation, and the like.

The column control circuit 33 includes a digital signal control circuit 33a that processes the received digital signal.

The address register 34 temporarily stores the address information from the input/output shift register 36. The address register 34 transmits the address information to the row control circuit 32 and the column control circuit 33.

The address register 34 has a function as a digital signal control circuit that processes the received digital signal (address information).

The data buffer 35 temporarily stores read data from the memory cell array 31 and write data from the input/output shift register 36.

The input/output shift register 36 temporarily stores data (signal DQ) transferred between the memory cell array 31 and the outside of the semiconductor device 1. The data (signal DQ) may include read data, write data, and (or) address information. The input/output shift register 36 transmits the address information to the address register 34. The input/output shift register 36 transmits the write data to the data buffer 35. The input/output shift register 36 transmits the read data supplied from the memory cell array 31 to the outside of the semiconductor device 1. The input/output shift register 36 can perform parallel-serial conversion of the data (signal DQ).

The input/output shift register 36 includes a digital signal control circuit 36a that processes the received digital signal.

The voltage generator 37 generates a plurality of voltages used for each of the write operation, the read operation, and the erase operation. The voltage generator 37 supplies the generated voltages to the row control circuit 32, the column control circuit 33, and the like.

The voltage generator 37 includes a digital signal control circuit 37a that processes the received digital signal.

The sequencer 38 controls the entire operation of the semiconductor device 1 based on various control signals such as a reset signal RESETn, a hold signal HOLDn, and a write protect signal Wn.

The sequencer 38 has a function as a digital signal control circuit that processes the received digital signals (various control signals).

Note that the semiconductor device 1 can include other components such as a status register. The status register temporarily stores a status signal indicating an operation status inside the semiconductor device 1 and an execution result of the operation.

Similarly to the first embodiment, an automatic place and route technique is used for layout design of various digital signal control circuits included in the semiconductor device 1.

### 2.2 Effect according to present embodiment

The configuration according to the present embodiment provides the same effects as those of the first embodiment.

### 3. Third embodiment

Next, a third embodiment will be described. In the third embodiment, a case where the semiconductor device 1 is a dynamic random access memory (DRAM) will be described. Note that the semiconductor device 1 may be a volatile semiconductor memory device other than the DRAM. For example, the semiconductor device 1 may be a static RAM (SRAM). Hereinafter, differences from the first and second embodiments will be mainly described.

### 3.1 Overall configuration of semiconductor device

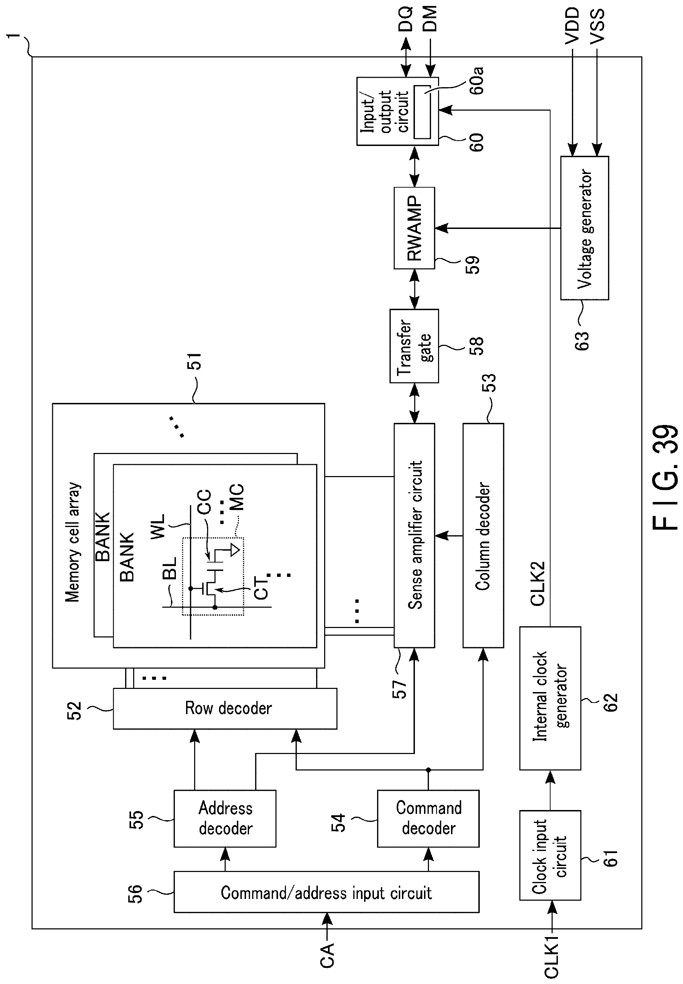

An example of an overall configuration of the semiconductor device 1 will be described with reference to FIG. 39. FIG. 39 is a block diagram illustrating the overall configuration of the semiconductor device 1. In FIG. 39, a part of coupling between components is indicated by an arrow line, but the coupling between the components is not limited thereto.

As illustrated in FIG. 39, the semiconductor device 1 is a DRAM.

The semiconductor device 1 includes a memory cell array 51, a row decoder 52, a column decoder 53, a command decoder 54, an address decoder 55, a command/address input circuit 56, a sense amplifier circuit 57, a transfer gate 58, a reading/writing amplifier circuit (RWAMP) 59, an input/output circuit 60, a clock input circuit 61, an internal clock generator 62, a voltage generator 63, and the like.

The memory cell array 51 includes a plurality of memory cells MC. Each of the memory cells MC of the DRAM51 includes a cell capacitor CC and a cell transistor CT. A gate of the cell transistor CT is coupled to a corresponding one of a plurality of word lines WL. One end of a current path of the cell transistor CT is coupled to a bit line BL. The other end of the current path of the cell transistor CT is coupled to one end of the cell capacitor CC. The other end of the cell capacitor CC is grounded. The cell capacitor CC can store an amount of charge corresponding to data to be stored. The cell transistor CT switches conduction/non-conduction (selection/non-selection of the memory cell MC) between the cell capacitor CC and the bit line BL. The memory cells MC is arranged in a two-dimensional array or a three-dimensional array in the memory cell array 51.

For example, the memory cell array 51 includes a plurality of banks. Each bank is a control unit including a plurality of memory cells. The banks are operable independently of each other.

The row decoder 52 controls selection/non-selection of a row (for example, word line WL) of the memory cell array 51 based on a decoding result of address information and a decoding result of a command.

The column decoder 53 controls selection/non-selection of a column (for example, bit line BL) of the memory cell array 51 based on the decoding result of the address information and the decoding result of the command.

The command decoder 54 decodes the command from the command/address input circuit 56. The command decoder 54 transmits the decoding result of the command to the row decoder 52 and the column decoder 53.

The address decoder 55 decodes the address information from the command/address input circuit 56. The address decoder 55 transmits the decoding result of the address information to the row decoder 52 and the column decoder 53.

The command/address input circuit 56 receives a command/address signal CA supplied from the outside. The command/address signal CA includes a command and address information. The command/address input circuit 56 transmits the command to the command decoder 54. The command/address input circuit 56 transmits the address information to the address decoder 55.

The sense amplifier circuit 57 senses and amplifies a signal from the memory cell MC during the read operation. The sense amplifier circuit 57 transmits the signal from the memory cell MC as read data to the input/output circuit 60 via the transfer gate 58 and the reading/writing amplifier circuit 59. The sense amplifier circuit 57 receives write data from the input/output circuit 60 via the transfer gate 58 and the reading/writing amplifier circuit 59. The sense amplifier circuit 57 outputs a signal corresponding to the write data to the bit line BL.

The transfer gate 58 controls data transfer between the sense amplifier circuit 57 and the reading/writing amplifier circuit 59.

The reading/writing amplifier circuit 59 amplifies a level (signal value) of the signal corresponding to the read data and a level of the signal corresponding to the write data.

The input/output circuit 60 functions as an interface circuit of data (signal DQ) transferred between the memory cell array 51 and the outside of the DRAM50. The input/output circuit 60 transmits the write data to the memory cell array 51 at a timing synchronized with an internal clock CLK2. The input/output circuit 60 transmits the read data to a device outside the DRAM50 at a timing synchronized with the internal clock CLK2. For example, the input/output circuit 60 receives a data mask signal DM. As a result, the input/output circuit 60 performs mask processing on the data (signal DQ).

The input/output circuit 60 includes a digital signal control circuit 60a that processes the received digital signal.

The clock input circuit 61 receives a clock (hereinafter, referred to as external clock) CLK1 from the outside. The clock input circuit 61 sends the external clock CLK1 to the internal clock generator 62.

The internal clock generator 62 generates the internal clock CLK2 based on the external clock CLK1. The internal clock generator 62 transmits the generated internal clock CLK2 to the input/output circuit 60 and the like.

The voltage generator 63 generates a plurality of voltages to be used for various operations, respectively, of the DRAM50 using the power supply voltage VDD and the ground voltage VSS from the outside. The voltage generator 63 transmits the generated voltages to another circuit (for example, reading/writing amplifier circuit 59).

Similarly to the first embodiment, an automatic place and route technique is used for layout design of digital signal control circuits included in the semiconductor device 1.

### 3.2 Effect according to present embodiment

The configuration according to the present embodiment provides the same effects as those of the first embodiment.

### 4. Fourth embodiment

Next, a fourth embodiment will be described. In the fourth embodiment, a case where the semiconductor device 1 is an image sensor will be described. Hereinafter, differences from the first to third embodiments will be mainly described.

### 4.1 Overall configuration of semiconductor device

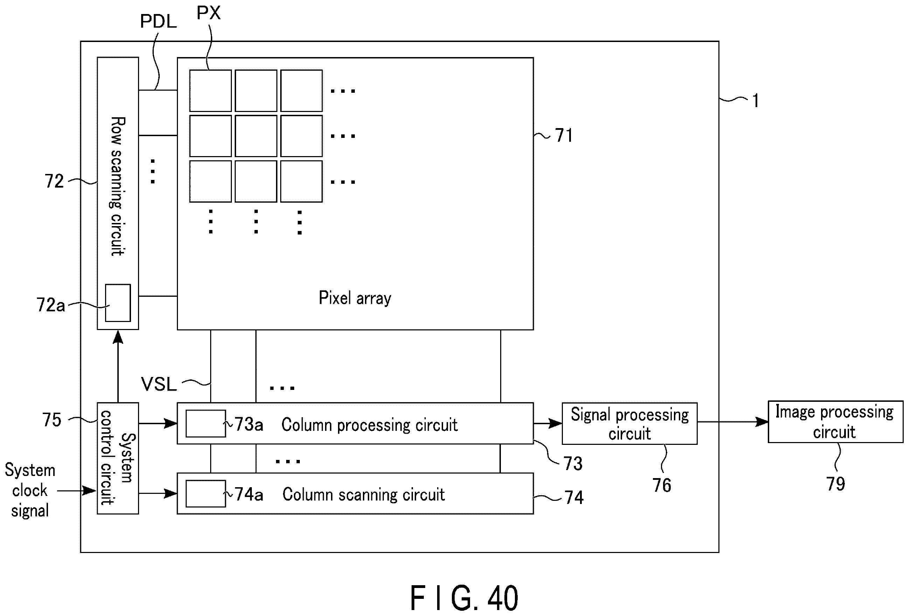

An example of an overall configuration of the semiconductor device 1 will be described with reference to FIG. 40. FIG. 40 is a block diagram illustrating the overall configuration of the semiconductor device 1. In FIG. 40, a part of coupling between components is indicated by an arrow line, but the coupling between the components is not limited thereto.

As illustrated in FIG. 40, the semiconductor device 1 is an image sensor.

The semiconductor device 1 includes a pixel array 71, a row scanning circuit 72, a column processing circuit 73, a column scanning circuit 74, a system control circuit 75, and a signal processing circuit 76.

The pixel array 71 includes a plurality of pixels PX. The pixels PX are placed in a two-dimensional lattice shape along a row direction and a column direction. Each pixel PX includes a photoelectric conversion element. The photoelectric conversion element generates a charge corresponding to an amount of received light and stores the generated charge. A filter may be provided in the pixel array 71 with respect to a light incident surface of each pixel PX. For example, array patterns of a plurality of the filters are, for example, Bayer patterns.

In the pixel array 71, the pixels PX arranged in the row direction are commonly coupled to a pixel drive line PDL. In the pixel array 71, the pixels PX arranged in the column direction are commonly coupled to a corresponding one of a plurality of vertical signal lines VSL.

The row scanning circuit 72 is coupled to one ends of a plurality of the pixel drive lines PDL. The row scanning circuit 72 generates a drive signal for driving signal reading from the pixel PX. The row scanning circuit 72 drives all the pixels PX of the pixel array 71 simultaneously or row by row via the pixel drive lines PDL.

The row scanning circuit 72 includes a digital signal control circuit 72a that processes the received digital signal.

Signals output from the pixels PX driven by the row scanning circuit 72 are supplied to the column processing circuit 73 through each of the vertical signal lines VSL for each of the pixels PX arranged in the row direction. The column processing circuit 73 performs predetermined signal processing on the signal supplied via the vertical signal line VSL. Thus, the column processing circuit 73 generates a pixel signal. The column processing circuit 73 can temporarily store the generated pixel signal. For example, the column processing circuit 73 performs noise removal processing, analog-digital conversion (AD conversion) processing, and the like. The digital signal obtained by the AD conversion is output to the signal processing circuit 76.

The column processing circuit 73 includes a digital signal control circuit 73a that processes the received digital signal.

The column scanning circuit 74 sequentially selects a reading circuit corresponding to an array of the pixel signals of the column processing circuit 73. By selective scanning by the column scanning circuit 74, a pixel signal subjected to signal processing for each pixel in the column processing circuit 73 is output based on a predetermined order.

The column scanning circuit 74 includes a digital signal control circuit 74a that processes the received digital signal.

The system control circuit 75 receives a system clock signal and the like via a controller (not illustrated) outside the image sensor 70. The system control circuit 75 includes a timing generator and the like. The timing generator generates various timing signals based on the system clock signal. As a result, the system control circuit 75 drives the row scanning circuit 72, the column processing circuit 73, the column scanning circuit 74, and the like based on the generated various timing signals.

The system control circuit 75 has a function as a digital signal control circuit that processes a received digital signal.

The signal processing circuit 76 has at least an arithmetic processing function. The signal processing circuit 76 performs various types of signal processing such as arithmetic processing on the pixel signal output from the column processing circuit 73.

The signal processing circuit 76 has a function as a digital signal control circuit that processes the received digital signal.

Note that the digital signal output from the signal processing circuit 76 is output to an image processing circuit 79 outside the image sensor 70. The image processing circuit 79 performs predetermined processing on the digital signal. As a result, an image signal for displaying an image on a predetermined display device is generated.

Similarly to the first embodiment, an automatic place and route technique is used for layout design of digital signal control circuits included in the semiconductor device 1.

### 4.2 Effect according to present embodiment

The configuration according to the present embodiment provides the same effects as those of the first embodiment.

### 5. Fifth embodiment

Next, a fifth embodiment will be described. In the fifth embodiment, a case where the semiconductor device 1 is a magnetoresistive random access memory (MRAM) using a resistance change element as a memory element will be described. In the case of the MRAM, an element (also referred to as MTJ element) having a magnetoresistive effect by a magnetic tunnel junction (MTJ) is included as the resistance change element. Hereinafter, differences from the first to fourth embodiments will be mainly described. Note that the semiconductor device using the resistance change element as the memory element may be, for example, a resistive random access memory (ReRAM), a phase-change random access memory (PCRAM), or the like.

### 5.1 Overall configuration of semiconductor device

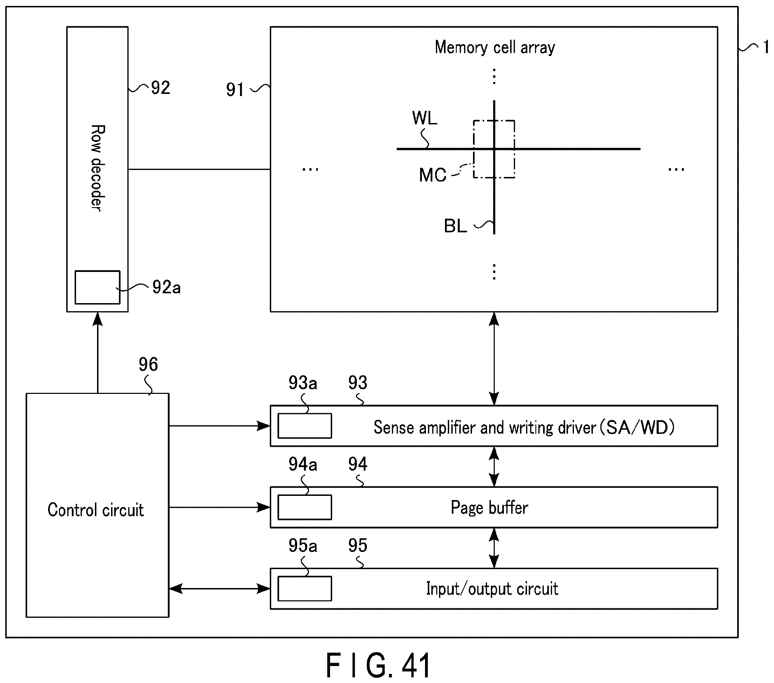

An example of an overall configuration of the semiconductor device 1 will be described with reference to FIG. 41. FIG. 41 is a block diagram illustrating the overall configuration of the semiconductor device 1. In FIG. 41, a part of coupling between components is indicated by an arrow line, but the coupling between the components is not limited thereto.

As illustrated in FIG. 41, the semiconductor device 1 includes a memory cell array 91, a row decoder 92, a sense amplifier and writing driver (SA/WD) 93, a page buffer 94, an input/output circuit 95, and a control circuit 96.

The memory cell array 91 includes a plurality of memory cells MC associated with a row and a column. Then, the memory cells MC in the same row are coupled to the same word line WL, and both ends of the memory cells MC in the same column are coupled to the same bit line BL. The bit line BL includes, for example, a local bit line and a global bit line. The memory cell MC includes a resistance change element. The resistance change element functions as a memory element that can be written data by a change in its resistance state, stores the written data in a non-volatile manner, and can be read the data.

The row decoder 92 is coupled to the memory cell array 91 via the word line WL. The row decoder 92 decodes a row address designating a row direction of the memory cell array 91. Then, the word line WL is selected according to a decoding result, and a voltage necessary for an operation such as writing and reading of data is supplied to the selected word line WL.

The row decoder 92 includes a digital signal control circuit 92a that processes the received digital signal.

The SA/WD93 is coupled to the memory cell array 91 via the bit line BL. The SA/WD93 supplies a voltage to the memory cell MC to be operated via the bit line BL, and writes and reads data to and from the memory cell MC. More specifically, a writing driver WD of the SA/WD93 writes data to the memory cell MC. In addition, a sense amplifier SA of the SA/WD93 reads data from the memory cell MC.

The SA/WD93 includes a digital signal control circuit 93a that processes the received digital signal.

The page buffer 94 temporarily holds data to be written into the memory cell array 91 and data read from the memory cell array 91 in units of data called page.

The page buffer 94 includes a digital signal control circuit 94a that processes the received digital signal.

The input/output circuit 95 sends various signals received from the outside of the semiconductor device 1 to the control circuit 96 and the page buffer 94, and sends various information from the control circuit 96 and the page buffer 94 to the outside of the semiconductor device 1.

The input/output circuit 95 includes a digital signal control circuit 95a that processes the received digital signal.

The control circuit 96 is coupled to the row decoder 92, the SA/WD93, the page buffer 94, and the input/output circuit 95. The control circuit 96 controls the row decoder 92, the SA/WD93, and the page buffer 94 according to various signals received by the input/output circuit 95 from the outside of the semiconductor device 1.

The control circuit 96 has a function as a digital signal control circuit that processes the received digital signal.

Similarly to the first embodiment, an automatic place and route technique is used for layout design of digital signal control circuits included in the semiconductor device 1.

### 5.2 Circuit configuration of memory cell array

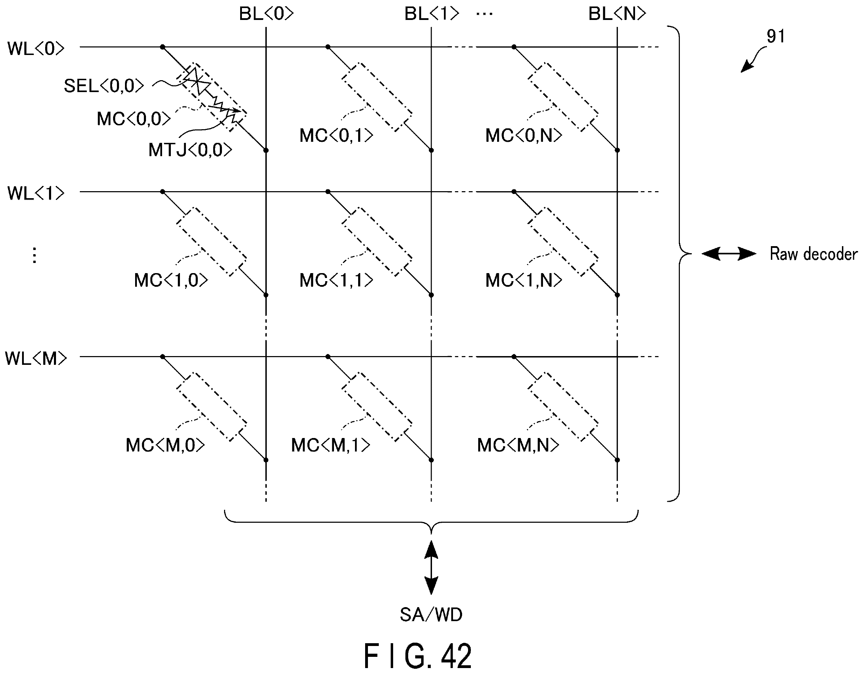

Next, an example of a configuration of the memory cell array 91 will be described with reference to FIG. 42. FIG. 42 is a circuit diagram of the memory cell array 91. In the example of FIG. 42, the memory cell MC, the word line WL, and the bit line BL are classified by subscripts including an index ("<>").

As illustrated in FIG. 42, the memory cells MC are placed in a matrix in the memory cell array 91. Each memory cell MC is associated with a set of one of the bit lines BL (BL<0>, BL<1>,..., BL<N>) and one of the word lines WL (WL<0>, WL<1>,..., WL<M>) (M and N are arbitrary integers). That is, a memory cell MC<i, j> (0 ≤ i ≤ M, 0 ≤ j ≤ N) is coupled between a word line WL<i> and a bit line BL<j>.

The memory cell MC<i, j> includes a selector SEL<i, j> and a magnetoresistive effect element MTJ<i, j>. The selector SEL<i, j> and the magnetoresistive effect element MTJ<i, j> are coupled in series. For example, one end of the selector SEL<i, j> is coupled to one word line WL<i>, and the other end is coupled to one end of the magnetoresistive effect element MTJ<i, j>. The other end of the magnetoresistive effect element MTJ<i, j> is coupled to one bit line BL<j>.

The selector SEL (hereinafter, also referred to as "switching element".) functions as a switch that controls the supply of a current to a corresponding magnetoresistive effect element MTJ during the write operation and the read operation to the magnetoresistive effect element MTJ. More specifically, for example, in a case where the voltage applied to the memory cell MC is less than a preset threshold voltage, the selector SEL in the memory cell MC cuts off the current as an insulator having a large resistance value (enters an off state). On the other hand, in a case where the voltage applied to the memory cell MC is equal to or higher than the threshold voltage, the selector SEL causes the current to flow as a conductor having a small resistance value (enters an on state). That is, the selector SEL has a function of switching whether to flow or cut off the current according to the magnitude of the voltage applied to the memory cell MC regardless of the direction of the flowing current.

The selector SEL may be, for example, a two-terminal switching element. When the voltage applied between the two terminals is less than the threshold voltage, the selector SEL is in a high resistance state or a non-conduction state in which almost no electricity is supplied. When the voltage applied between the two terminals is equal to or higher than the threshold voltage, the selector SEL is in a low resistance state, that is, an electrically conductive state. The switching element may have this function whichever polarity the voltage has.

The magnetoresistive effect element MTJ functions as a memory element that stores data in a non-volatile manner. The magnetoresistive effect element MTJ can be switched to the low resistance state or the high resistance state by the current whose supply is controlled by the selector SEL. The magnetoresistive effect element MTJ can write data by a change in its resistance state.

### 5.3 Effect according to present embodiment

The configuration according to the present embodiment provides the same effects as those of the first embodiment.

### 6. Variation and the like

The semiconductor devices according to the above embodiments include a first cell (1010). The first cell includes a first PMOS transistor (TP10), a second PMOS transistor (TP11) arranged side by side with the first PMOS transistor in a first direction (X direction) and configured to share one end with one end of the first PMOS transistor, a first NMOS transistor (TN10) arranged side by side with the first PMOS transistor in a second direction (Y direction) intersecting the first direction, a second NMOS transistor (TN11) arranged side by side with the first NMOS transistor in the first direction and configured to share one end with one end of the first NMOS transistor, a first interconnect (130_90) electrically coupled to another end of the first PMOS transistor, a second interconnect (130_91) electrically coupled to the one end of the first PMOS transistor and the one end of the second PMOS transistor, a third interconnect (130_92) electrically coupled to another end of the second PMOS transistor, a power supply voltage interconnect (150_1) extending in the second direction, provided above the first interconnect, the second interconnect, and the third interconnect, and electrically coupled to the first interconnect, the second interconnect, and the third interconnect, a fourth interconnect (130_93) electrically coupled to another end of the first NMOS transistor, a fifth interconnect (130_94) electrically coupled to the one end of the first NMOS transistor and the one end of the second NMOS transistor, a sixth interconnect (130_95) electrically coupled to another end of the second NMOS transistor, a ground voltage interconnect (150_3) extending in the second direction, provided above the fourth interconnect, the fifth interconnect, and the sixth interconnect, and electrically coupled to the fourth interconnect, the fifth interconnect, and the sixth interconnect, and a seventh interconnect (130a) provided in the same layer as the first to sixth interconnects and not electrically coupled to the first PMOS transistor, the second PMOS transistor, the first NMOS transistor, and the second NMOS transistor.

By applying the above embodiments, it is possible to provide a semiconductor device capable of suppressing an increase in development cost and an extension of the development work period.

The embodiment is not limited to the embodiments described above, and various variations are possible.

For example, the semiconductor device 1 may be any semiconductor device to which the automatic place and route technique can be applied. The automatic place and route technique may be used for purposes other than the layout of the digital control circuit.

For example, in the first embodiment, as a specific example of using the through cell, the case where the M1 interconnect 130 of the ECO base cell 1010 (ECO_NOR) in which the NOR circuit is configured and the M1 interconnect 130 of the ECO base cell 1010 (ECO_I) in which the inverter circuit is configured are coupled via the ECO base cell 1010 (ECO_T) in which the through cell is configured has been described, but the present invention is not limited thereto. For example, the M1 interconnect 130 of the ECO base cell 1010 (ECO_NOR) in which the NOR circuit is configured and the M1 interconnect 130 of any one of the ECO base cell 1010 (ECO_NAND) in which the NAND circuit is configured, the ECO base cell 1010 (ECO_NOR) in which another NOR circuit is configured, the ECO base cell 1010 (ECO_B) in which the buffer circuit is configured, the standard cell 1001 of the NAND circuit, the standard cell 1002 of the NOR circuit, the standard cell 1003 of the inverter circuit, or the standard cell 1004 of the buffer circuit may be coupled via the ECO base cell 1010 (ECO_T) in which the through cell is configured. For example, the M1 interconnect 130 of the ECO base cell 1010 (ECO_NAND) in which the NAND circuit is configured and the M1 interconnect 130 of any one of the ECO base cell 1010 (ECO_NAND) in which another NAND circuit is configured, the ECO base cell 1010 (ECO_I) in which the inverter circuit is configured, the ECO base cell 1010 (ECO_B) in which the buffer circuit is configured, the standard cell 1001 of the NAND circuit, the standard cell 1002 of the NOR circuit, the standard cell 1003 of the inverter circuit, or the standard cell 1004 of the buffer circuit may be coupled via the ECO base cell 1010 (ECO_T) in which the through cell is configured. For example, the M1 interconnect 130 of the ECO base cell 1010 (ECO_I) in which the inverter circuit is configured and the M1 interconnect 130 of any one of the ECO base cell 1010 (ECO_I) in which another inverter circuit is configured, the ECO base cell 1010 (ECO_B) in which the buffer circuit is configured, the standard cell 1001 of the NAND circuit, the standard cell 1002 of the NOR circuit, the standard cell 1003 of the inverter circuit, or the standard cell 1004 of the buffer circuit may be coupled via the ECO base cell 1010 (ECO_T) in which the through cell is configured. For example, the M1 interconnect 130 of the ECO base cell 1010 (ECO_B) in which the buffer circuit is configured and the M1 interconnect 130 of any one of the ECO base cell 1010 (ECO_B) in which another buffer circuit is configured, the standard cell 1001 of the NAND circuit, the standard cell 1002 of the NOR circuit, the standard cell 1003 of the inverter circuit, or the standard cell 1004 of the buffer circuit may be coupled via the ECO base cell 1010 (ECO_T) in which the through cell is configured.

For example, the through cells in the regions of the coordinates (4, 2) and (5, 2) in the planar layout (FIG. 26) of the first embodiment may correspond to the ECO base cells 1010a and 1010b in FIGS. 27 to 29. The through cell in the region of the coordinates (5, 2) in the planar layout (FIG. 26) may have the M1 interconnect 130a_2 in the through cell illustrated in FIGS. 16, 32, and 34. The ECO logic cell in the region of the coordinates (5, 1) in the planar layout (FIG. 26) may be coupled to any of the standard cell 1001 of the NAND circuit, the standard cell 1002 of the NOR circuit, and the standard cell 1003 of the inverter circuit in the region across the coordinates (5, 3) and (6, 3) in FIG. 26 via the M1 interconnect 130a_2 in the through cell in the region of the coordinates (5, 2). The through cells in the regions of the coordinates (4, 3) and (4, 4) in the planar layout (FIG. 26) may have the M1 interconnect 130a_2 in the through cell illustrated in FIGS. 16, 32, and 34.

For example, the case where the standard cell and the ECO base cell are planar cells has been described in the first embodiment, but the present invention is not limited thereto. The standard cell and the ECO base cell may have a configuration of FinFETs, Nanosheets, or the like.

In the FinFETs, a gate electrode faces two or more surfaces of a channel region. The channel region is formed in a convex shape formed at a surface of the semiconductor substrate. A plurality of channels may be provided in one transistor.

In the Nanosheets, gate electrodes are opposed so as to enclose a channel region. The channel region is formed in a flat plate-shaped semiconductor layer. A plurality of the flat-plate-shaped semiconductor layers may be stacked apart from each other.

Furthermore, the "coupling" in the above embodiments also encompasses a state in which coupling is indirectly made with, for example, a transistor or a resistor interposed between two components.

While certain embodiments have been described, these embodiments have been presented by way of example only, and are not intended to limit the scope of the inventions. Indeed, the novel methods and systems described herein may be embodied in a variety of other forms; furthermore, various omissions, substitutions and changes in the form of the methods and systems described herein may be made without departing from the spirit of the inventions. The accompanying claims and their equivalents are intended to cover such forms or modifications as would fall within the scope and spirit of the inventions.

## Claims

1. A semiconductor device comprising a first cell (1010), the first cell including:
a first PMOS transistor (TP10);
a second PMOS transistor (TP11) arranged side by side with the first PMOS transistor in a first direction (X direction) and configured to share one end with one end of the first PMOS transistor;
a first NMOS transistor (TN10) arranged side by side with the first PMOS transistor in a second direction (Y direction) intersecting the first direction;
a second NMOS transistor (TN11) arranged side by side with the first NMOS transistor in the first direction and configured to share one end with one end of the first NMOS transistor;
a first interconnect (130_90) electrically coupled to another end of the first PMOS transistor;
a second interconnect (130_91) electrically coupled to the one end of the first PMOS transistor and the one end of the second PMOS transistor;
a third interconnect (130_92) electrically coupled to another end of the second PMOS transistor;
a power supply voltage interconnect (150_1) extending in the second direction, provided above the first interconnect, the second interconnect, and the third interconnect, and electrically coupled to the first interconnect, the second interconnect, and the third interconnect;
a fourth interconnect (130_93) electrically coupled to another end of the first NMOS transistor;
a fifth interconnect (130_94) electrically coupled to the one end of the first NMOS transistor and the one end of the second NMOS transistor;
a sixth interconnect (130_95) electrically coupled to another end of the second NMOS transistor;
a ground voltage interconnect (150_3) extending in the second direction, provided above the fourth interconnect, the fifth interconnect, and the sixth interconnect, and electrically coupled to the fourth interconnect, the fifth interconnect, and the sixth interconnect; and
a seventh interconnect (130a_1) provided in the same layer as the first to sixth interconnects and not electrically coupled to the first PMOS transistor, the second PMOS transistor, the first NMOS transistor, and the second NMOS transistor.

2. The semiconductor device according to claim 1, wherein
a gate of the first PMOS transistor and a gate of the second PMOS transistor are electrically coupled to the power supply voltage interconnect via the second interconnect, and
a gate of the first NMOS transistor and a gate of the second NMOS transistor are electrically coupled to the ground voltage interconnect via the fifth interconnect.

3. The semiconductor device according to claim 1, wherein
a gate of the first PMOS transistor, a gate of the second PMOS transistor, a gate of the first NMOS transistor, and a gate of the second NMOS transistor are electrically coupled to the power supply voltage interconnect via the second interconnect.

4. The semiconductor device according to claim 1, wherein
a gate of the first PMOS transistor, a gate of the second PMOS transistor, a gate of the first NMOS transistor, and a gate of the second NMOS transistor are electrically coupled to the ground voltage interconnect via the fifth interconnect.

5. The semiconductor device according to claim 1, wherein
the seventh interconnect passes above a gate of the first PMOS transistor and a gate of the first NMOS transistor, above a first element isolation region surrounding an active area (102) of the first PMOS transistor and the second PMOS transistor, and above a second element isolation region surrounding an active area (104) of the first NMOS transistor and the second NMOS transistor.

6. The semiconductor device according to claim 2, further comprising:
a second cell (1010) adjacent to one end of the first cell in the second direction; and
a third cell (1010) adjacent to another end of the first cell in the second direction,
wherein the second cell and the third cell are electrically coupled via the seventh interconnect.

7. The semiconductor device according to claim 6, wherein
each of the second cell and the third cell is one of a NAND circuit (ECO_NAND), a NOR circuit (ECO_NOR), an inverter circuit (ECO_I), and a buffer circuit (ECO_B).

8. The semiconductor device according to claim 1, wherein
the first cell further includes an eighth interconnect (130a_2) passing through the first cell in the second direction, provided in the same layer as the first to seventh interconnects, and not electrically coupled to the first PMOS transistor, the second PMOS transistor, the first NMOS transistor, the second NMOS transistor, and the seventh interconnect.

9. The semiconductor device according to claim 8, wherein
the eighth interconnect passes above a gate of the second PMOS transistor and a gate of the second NMOS transistor, above a first element isolation region surrounding an active area (102) of the first PMOS transistor and the second PMOS transistor, and above a second element isolation region surrounding an active area (104) of the first NMOS transistor and the second NMOS transistor.

10. The semiconductor device according to claim 1, further comprising a fourth cell (1010) adjacent to the first cell in the first direction,
wherein the fourth cell includes:
a third PMOS transistor (TP10) adjacent to the second PMOS transistor in the first direction;
a fourth PMOS transistor (TP11) arranged side by side with the third PMOS transistor in the first direction and configured to share one end with one end of the third PMOS transistor;
a third NMOS transistor (TN10) adjacent to the second NMOS transistor in the first direction and arranged side by side with the third PMOS transistor in the second direction;
a fourth NMOS transistor (TN11) arranged side by side with the third NMOS transistor in the first direction and configured to share one end with one end of the third NMOS transistor;
a ninth interconnect (130_90) electrically coupling another end of the third PMOS transistor to the power supply voltage interconnect;
a tenth interconnect (130_91) electrically coupling the one end of the third PMOS transistor and the one end of the fourth PMOS transistor to the power supply voltage interconnect;
an eleventh interconnect (130_92) electrically coupling another end of the fourth PMOS transistor to the power supply voltage interconnect;
a twelfth interconnect (130_93) electrically coupling another end of the third NMOS transistor to the ground voltage interconnect;
a thirteenth interconnect (130_94) electrically coupling the one end of the third NMOS transistor and the one end of the fourth NMOS transistor to the ground voltage interconnect; and
a fourteenth interconnect (130_95) electrically coupling another end of the fourth NMOS transistor to the ground voltage interconnect.

11. The semiconductor device according to claim 10, wherein
the seventh interconnect passes through the first cell and the fourth cell in the second direction, and is not electrically coupled to the first to fourth PMOS transistors and the first to fourth NMOS transistors.

12. The semiconductor device according to claim 11, wherein
the seventh interconnect passes above a gate of the third PMOS transistor and a gate of the second NMOS transistor, above a third element isolation region surrounding an active area (102) of the third PMOS transistor and the fourth PMOS transistor, and above a second element isolation region surrounding an active area (104) of the first NMOS transistor and the second NMOS transistor.

13. The semiconductor device according to claim 1, wherein
the one end, the other end, and a gate of the first PMOS transistor are electrically coupled to the power supply voltage interconnect,
the one end, the other end, and a gate of the second PMOS transistor are electrically coupled to the power supply voltage interconnect,
the one end, the other end, and a gate of the first NMOS transistor are electrically coupled to the ground voltage interconnect, and
the one end, the other end, and a gate of the second NMOS transistor are electrically coupled to the ground voltage interconnect.

14. The semiconductor device according to claim 1, wherein
the one end, the other end, and a gate of the first PMOS transistor are electrically coupled to the power supply voltage interconnect,
the one end, the other end, and a gate of the second PMOS transistor are electrically coupled to the power supply voltage interconnect,
the one end and the other end of the first NMOS transistor are electrically coupled to the ground voltage interconnect, and a gate of the first NMOS transistor is electrically coupled to the power supply voltage interconnect, and
the one end and the other end of the second NMOS transistor are electrically coupled to the ground voltage interconnect, and a gate of the second NMOS transistor is electrically coupled to the power supply voltage interconnect.

15. The semiconductor device according to claim 1, wherein
the one end and the other end of the first PMOS transistor are electrically coupled to the power supply voltage interconnect, and a gate of the first PMOS transistor is electrically coupled to the ground voltage interconnect,
the one end and the other end of the second PMOS transistor are electrically coupled to the power supply voltage interconnect, and a gate of the second PMOS transistor is electrically coupled to the ground voltage interconnect,
the one end, the other end, and a gate of the first NMOS transistor are electrically coupled to the ground voltage interconnect, and
the one end, the other end, and a gate of the second NMOS transistor are electrically coupled to the ground voltage interconnect.

16. A method for designing a semiconductor device, the method comprising:
placing a plurality of first cells (1001, 1002, 1003, or 1004) (S1);
interconnect-coupling the first cells (S2);
placing a plurality of second cells (1010(ECO_C)) in a region where the first cells are not placed (S3);
changing at least one of the second cells to a logic cell (S9) and changing at least another one of the second cells to a third cell (1010(ECO_T)) (S13); and
coupling the logic cell to a first interconnect (130a) passing through the third cell and not electrically coupled to the third cell (S11).

17. The method for designing a semiconductor device according to claim 16, wherein
each of the first cells is one of a NAND circuit (1001), a NOR circuit (1002), an inverter circuit (1003), and a buffer circuit (1004),
each of the second cells is a decoupling capacitor, and
the logic cell is one of a NAND circuit (ECO_NAND), a NOR circuit (ECO_NOR), an inverter circuit (ECO_I), and a buffer circuit (ECO_B).

18. The method for designing a semiconductor device according to claim 16, wherein
when the logic cell cannot be interconnect-coupled in the changing, at least the other one of the second cells to the third cell is changed.

19. A method for manufacturing a semiconductor device, the method comprising:
placing a plurality of first cells (1001, 1002, 1003, or 1004) (S1);
interconnect-coupling the first cells (S2);
placing a plurality of second cells (1010(ECO_C)) in a region where the first cells are not placed (S3);
making a mask for use in formation of a transistor (S6);
manufacturing a transistor based on the mask (S7);
changing at least one of the second cells to a logic cell (S9) and changing at least another one of the second cells to a third cell (1010(ECO_T)) (S13); and
coupling the logic cell to a first interconnect (130a) passing through the third cell and not electrically coupled to the third cell (S11),
wherein the making the mask and the coupling the logic cell and the first interconnect are executed in parallel.

20. The method for manufacturing a semiconductor device according to claim 19, wherein
the manufacturing the transistor and the coupling the logic cell to the first interconnect are executed in parallel.
